# EUROPEAN PATENT SPECIFICATION

(11) **EP 4 429 422 B1**
(45) Date of publication and mention of the grant of the patent: **28.01.2026**
(21) Application number: 22897220.4
(22) Date of filing: 05.08.2022
(51) Int. Cl.: H05K 7/20, F28D 15/02, B23P 15/26

(54) **VAPOR CHAMBER COMPRISING MICROSTRUCTURE LAYER**
DAMPFKAMMER MIT MIKROSTRUKTURSCHICHT
CHAMBRE À VAPEUR COMPRENANT UNE COUCHE DE MICROSTRUCTURE

(30) Priority: 26.11.2021 CN 202111422366
(43) Date of publication of application: 11.09.2024
(73) Proprietor: Huawei Technologies Co., Ltd., Shenzhen, Guangdong 518129 (CN)
(72) Inventor: LIU, Xiaobang, Shenzhen, Guangdong 518129 (CN); YANG, Jie, Shenzhen, Guangdong 518129 (CN); LIU, Hua, Shenzhen, Guangdong 518129 (CN)
(74) Representative: Maiwald GmbH
(86) International application number: PCT/CN2022/110602
(87) International publication number: WO 2023/093125

(56) References cited:
- WO-A1-2020/184620
- CN-A- 101 848 629
- CN-A- 110 160 385
- CN-A- 110 303 153
- CN-A- 111 465 293
- CN-A- 112 524 983
- CN-A- 113 245 543
- JP-U- 3 163 111
- US-A1- 2012 031 588
- US-A1- 2012 031 588
- US-A1- 2020 049 421

## Description

### TECHNICAL FIELD

The present invention relates to the field of vapor chamber technologies, and in particular, to a vapor chamber with a microstructure layer, a circuit module, an electronic device, and a method for forming a vapor chamber. More specifically, the present invention relates to a vapor chamber as defined in the preamble of claim 1, and as illustrated in US2020/049241A.

### BACKGROUND

As an electronic device is increasingly intelligent, an operational processing capability of the electronic device is also continuously improved. Power consumption of electronic components in an electronic device continuously increases. Heat consumption of the electronic components in the electronic device is also growing.

Currently, the electronic device may dissipate heat of the electronic components by using a vapor chamber (Vapor Chamber, VC). However, with an increasing requirement of users for thinness and lightweight of the electronic device, a thickness of the component in the electronic device needs to be further reduced. Currently, vapor chambers provided by manufacturers are relatively thick, and are difficult to meet the requirement of users for thinness and lightweight of the electronic device.

### SUMMARY

Embodiments of this application provide a vapor chamber with a microstructure layer, a circuit module, an electronic device, and a method for forming a vapor chamber. The vapor chamber includes a first plate cover, a second plate cover, and a capillary structure, where the first plate cover and the second plate cover jointly form an accommodating cavity. Capillary structures are in a shape of a long strip, and are arranged at intervals in the accommodating cavity in parallel. Two opposite surfaces of the capillary structure are respectively connected to the first plate cover and the second plate cover, to support the first plate cover and the second plate cover in an overlapping direction of the first plate cover and the second plate cover. A vapor channel is formed around the capillary structure, and the capillary structure is filled with a working medium. The microstructure layer is introduced to an inner surface of the accommodating cavity and the capillary structure in the vapor chamber, so that a liquid-phase working medium in a condensation region returns to an evaporation region on the vapor chamber after being guided by the microstructure layer. The vapor chamber can implement timely return of the liquid-phase working medium in the condensation region, and improve a problem that liquid droplets gather in the condensation region in the vapor chamber and are less likely to return to the evaporation region. The present invention is defined by the appended claims. In the following, aspects not covered by the appended claims are for increasing understandability of the present invention.

A first aspect of this application provides a vapor chamber with a microstructure layer, to dissipate heat for a heat source. The vapor chamber specifically includes a first plate cover, a second plate cover, a capillary structure, and a microstructure layer. The first plate cover and the second plate cover overlap along an overlapping direction, and jointly form a sealed accommodating cavity. A heat conductive surface configured to abut on the heat source is provided on a side that is of the first plate cover and that faces away from the accommodating cavity. The overlapping direction is a direction in which the vapor chamber and the heat source are stacked. The capillary structure is located in the accommodating cavity, and the capillary structure has a pair of a first overlapping surface and a second overlapping surface that are opposite to each other and perpendicular to the overlapping direction. The first overlapping surface of the capillary structure is connected to the second plate cover, and the second overlapping surface of the capillary structure is connected to the first plate cover to support the first plate cover and the second plate cover in the overlapping direction. The microstructure layer is provided on an inner surface of the accommodating cavity and a wall surface of capillary pores in the capillary structure. The microstructure layer is configured to guide a liquid-phase working medium in the vapor chamber. For example, between two capillary structures, the microstructure layer on the inner surface of the accommodating cavity is configured to guide, back to a nearby capillary structure, a liquid-phase working medium in a region other than a region connected to the capillary structure on the inner surface of the accommodating cavity, and the microstructure layer on the wall surface of capillary pores in the capillary structure is configured to further guide the liquid-phase working medium back to a region, in the accommodating cavity, close to the heat source. The heat conductive surface may be a part of a surface region on a side that is of the first plate cover and that is opposite to the second plate cover, that is, the heat conductive surface may also be referred to as a heat conductive region. The heat conductive surface on the first plate cover faces in an opposite direction to a surface that is of the first plate cover and that is configured to connect to the first overlapping surface of the capillary structure. In other words, the first overlapping surface, the second overlapping surface, and the heat conductive surface are sequentially arranged along the overlapping direction.

It may be understood that the heat source may be an electronic component in an electronic device. The electronic component may be any one of components such as an application processor (Multimedia Application Processor, MAP), a radio frequency amplifier (Radio Frequency Amplifier, RFA), a power amplifier (Power Amplifier, PA), a power management chip (Power Management IC, PMIC), a chip (for example, a system on chip (System on Chip, SOC)), a central processing unit (Central Processing Unit/Processor, CPU), and a power supply. The electronic device may be any one of electronic devices that have an electronic component with heat consumption, such as a mobile phone, a tablet computer, a watch, an e-reader, a notebook computer, a vehicle-mounted device, a web television, and a wearable device. The following describes the solution by using an example in which the electronic device is a mobile phone, and the electronic component is a chip with high heat generation and slow heat dissipation.

In other words, in an implementation of this application, the vapor chamber includes the first plate cover, the second plate cover, the sealed accommodating cavity formed by the first plate cover and the second plate cover, and at least one capillary structure distributed in parallel in the accommodating cavity. The at least one capillary structure is separately connected to the first plate cover and the second plate cover in an overlapping direction, to support the first plate cover and the second plate cover in the overlapping direction. The at least one capillary structure, the first plate cover, and the second plate cover jointly form a vapor channel. In some implementations, these vapor channels communicate with each other.

In addition, the first overlapping surface, the second overlapping surface, and the heat conductive surface are sequentially arranged along the overlapping direction, that is, the second overlapping surface of the capillary structure presses against a surface of a heat source through the first plate cover. In other words, a second overlapping surface of at least a part of the at least one capillary structure presses against the evaporation region in the vapor chamber. In one aspect, the capillary structure is configured to support the first plate cover and the second plate cover in the overlapping direction. In another aspect, the capillary structure is configured to guide the liquid-phase working medium in the condensation region back to the evaporation region.

According to the vapor chamber in this application, a microstructure layer is introduced to the inner surface of the accommodating cavity (that is, an inner surface of the first plate cover and an inner surface of the second plate cover) to improve wettability of the inner surface of the accommodating cavity, so that liquid droplets on the inner surface of the accommodating cavity and liquid droplets on two sides of the capillary structure can return to the capillary structure in time, and the liquid phase working medium can return to the evaporation region in time through the capillary structure. This avoids a lack of the liquid phase working medium in the evaporation region, and improves temperature uniformity performance of the vapor chamber.

In addition, a microstructure layer is also introduced to the capillary structure of the vapor chamber, to improve fluidity of the liquid phase working medium in the capillary structure, so that after flowing to the capillary structure, the liquid-phase working medium in the condensation region can be quickly guided back to the evaporation region by the capillary structure. This further improves a return speed of the liquid-phase working medium.

The vapor chamber directly supports the first plate cover and the second plate cover through a capillary structure, thereby saving thickness space occupied by another support component. Therefore, the vapor chamber can maximize a thickness of the vapor channel, and help reduce resistance for vapor. In addition, with the addition of the microstructure to the inner surface of the accommodating cavity, wettability of the inner surface of the accommodating cavity is enhanced without changing a structural size of the vapor chamber, and a driving force for liquid droplets to return to the capillary structure along the inner surface of the accommodating cavity is improved. In addition, the microstructure layer is introduced to the capillary structure, so that capillary performance of the capillary structure is strengthened, and a driving force for the liquid droplets to continue to return along the capillary structure is improved. In conclusion, the vapor chamber 10 can implement timely return of the liquid-phase working medium in the condensation region, and improves a problem that liquid droplets gather in the condensation region in the vapor chamber and are less likely to return to the evaporation region.

Further, in a storage and transportation process, the vapor chamber can effectively prevent a bump, which is formed on a surface of the vapor chamber due to freezing and bulging of a liquid droplet, thereby ensuring that the heat conductive surface of the vapor chamber closely abuts on an abutted surface of a heat source, and further improving a heat dissipation effect and heat dissipation stability of the vapor chamber.

In a possible implementation of the first aspect, in the vapor chamber, the capillary structure includes a plurality of strip-shaped capillary structure walls, the plurality of capillary structure walls are dispersedly distributed in the accommodating cavity, and a gap is formed between the inner surface of the accommodating cavity and a surface of each capillary structure wall other than the first overlapping surface and the second overlapping surface.

In the vapor chamber, the capillary structure includes the plurality of strip-shaped capillary structure walls, and the plurality of strip-shaped capillary structure walls are arranged at intervals in parallel, so that space occupied by the capillary structure is retained as much as possible while the vapor channel is properly arranged. This improves support strength of the capillary structure and further improves stability of the vapor chamber in use. In addition, a gap is formed between the inner surface of the accommodating cavity and a surface of each capillary structure wall other than the first overlapping surface and the second overlapping surface, to ensure that the vapor channels in the accommodating cavity communicate with each other, so that vapor formed in the evaporation region is quickly spread with a uniform temperature to all vapor channels in the vapor chamber. This improves a temperature uniformity effect of the vapor chamber and facilitates uniform heat dissipation performance of the vapor chamber.

In a possible implementation of the first aspect, in the vapor chamber, a plurality of first vapor channels are formed on two sides of the capillary structure walls, second vapor channels communicating with the plurality of first vapor channels are provided at ends of the capillary structure walls, and the microstructure layer is provided on the inner surface that is of the accommodating cavity and that is opposite to the first vapor channel and the second vapor channel.

In other words, in this implementation of this application, the microstructure layer is provided on the inner surface of the accommodating cavity that is opposite to the first vapor channel and the second vapor channel that communicate with each other, which facilitates flow of liquid droplets on the two sides of the capillary structure to the capillary structure. When no microstructure layer is provided in a region that is on the surface of the accommodating cavity and that is connected to the first overlapping surface and the second overlapping surface, strength of connection of the capillary structure with the first plate cover and the second plate cover is improved, and stability of the vapor chamber is further improved.

In a possible implementation of the first aspect, in the vapor chamber, a dimension range of the capillary structures in overlapping direction ranges from 0.05 mm to 0.5 mm, and a thickness range of the microstructure layers ranges from 0.1 µm to 20 µm.

It is not difficult to find that in this application, a size of the capillary structure in the overlapping direction is given at a millimeter level, and a thickness of the microstructure layer on the inner surface of the accommodating cavity and the wall surface of the capillary structure is given at a level of µm. In other words, the size of the microstructure layer in the overlapping direction is far less than the size of the capillary structure in the overlapping direction. In conclusion, the vapor chamber in this application can effectively improve the flow of the liquid-phase working medium in the vapor chamber without changing an original size, improve a degree of adaptation between the vapor chamber and an existing product, and further improve economic benefits.

In a possible implementation of the first aspect, in the vapor chamber, a feature size of a microstructure in the microstructure layer is less than a feature size of the capillary structure, where the feature size of the capillary structure is a pore diameter of the capillary pore in the capillary structure, and the feature size of the microstructure is a size of a technical feature related to wettability of the microstructure layer.

In a possible implementation of the first aspect, in the vapor chamber, the microstructure layer includes a plurality of wave-formed roll-up structures laid on the inner surface of the accommodating cavity, and a plurality of micropores are formed on a surface of each roll-up structure. The roll-up structure can enhance wettability of the inner surface of the accommodating cavity. "Laid" means that the wave-formed roll-up structure extends along the inner surface of the accommodating cavity.

In a possible implementation of the first aspect, in the vapor chamber, the feature size of the microstructure is a pore diameter of the micropore, and a pore diameter range of the micropore ranges from 0.1 µm to 10 µm.

In a possible implementation of the first aspect, a dimension range of a pore diameter of a micropore on the roll-up structure ranges from 0.5 µm to 3 µm.

In the vapor chamber, the microstructure layer includes the wave-formed roll-up structure, which increases roughness of the inner surface of the accommodating cavity. The micropore on the roll-up structure reduces hydrophobicity of the liquid-phase working medium on the inner surface of the accommodating cavity, so that a small-volume liquid droplet can also be spread on the inner surface of the accommodating cavity. This reduces difficulty in connecting the liquid droplet to the capillary structure, and the liquid-phase working medium in the condensation region can return to the evaporation region in time.

In a possible implementation of the first aspect, in the vapor chamber, the microstructure layer includes a plurality of microclusters laid on the inner surface of the accommodating cavity. A principle of the microcluster is the same as that of the micropore on the roll-up structure, and details are not described herein again.

In a possible implementation of the first aspect, in the vapor chamber, a feature size of the microstructure is a distance between two adjacent microclusters, and the distance between two adjacent microclusters ranges from 0.1 µm to 10 µm.

In a possible implementation of the first aspect, a dimension range of a pore diameter of the micropore on the roll-up structure ranges from 0.5 µm to 3 µm.

In a possible implementation of the first aspect, in the vapor chamber, the microstructure layer includes a plurality of microlines, an end of the microline is connected to the wall surface of the capillary pores in the capillary structure, and the other end of the microline extends toward the inside of the capillary pore.

In other words, in this implementation of this application, the microlines are densely laid on the wall surface of the capillary pores, and an end of the microline is connected to the wall surface of the capillary pores. By providing the microlines on the wall surface of the capillary structure, a capillary force of the capillary structure can be effectively improved without changing mechanical performance, corrosion resistance, thermal conduction, and other properties of the capillary structure, that is, fluidity of the liquid-phase working medium in the capillary structure can be improved.

It may be understood that the microstructure layer on the inner surface of the accommodating cavity may also include microlines, and details are not described herein.

In a possible implementation of the first aspect, in the vapor chamber, a feature size of the microstructure is a distance between two adjacent microlines, and the distance between two adjacent microlines ranges from 0.1 µm to 10 µm. The distance between two adjacent microlines is a distance from an end, of one of the microlines, connected to the wall surface of the capillary pores to an end, of the other microline, connected to the wall surface of the capillary pores.

In a possible implementation of the first aspect, the distance between two adjacent microlines ranges from 0.2 µm to 3 µm.

In a possible implementation of the first aspect, in the vapor chamber, the microstructure layer includes coral-shaped micro protrusions formed on the wall surface of the capillary pores in the capillary structure. Space between two adjacent micro protrusions on a coral-formed convex structure may be used as microspace, and the microspace can improve wettability of the capillary structure.

In a possible implementation of the first aspect, in the vapor chamber, a feature size of the microstructure is a distance between two adjacent micro protrusions, and the distance between two adjacent micro protrusions ranges from 0.1 µm to 10 µm.

In a possible implementation of the first aspect, the distance between two adjacent micro protrusions ranges from 0.2 µm to 5 µm.

In a possible implementation of the first aspect, in the vapor chamber, the accommodating cavity includes a condensation region, a first region of the condensation region is provided with the microstructure layer, and the first region is a region of the condensation region other than a region connected to the capillary structure. The condensation region is a part of region on the inner surface of the accommodating cavity that is away from a heat source, and in the part of region, a gas-phase working medium can be condensed into a liquid droplet. Generally, the condensation region is a region other than the evaporation region on the inner surface of the accommodating cavity.

In another possible implementation of the first aspect, the accommodating cavity includes a condensation region, and a microstructure layer is provided on the condensation region. The foregoing structure not only enables the liquid-phase working medium in the first region to flow to an adjacent capillary structure, but also enables the liquid-phase working medium to flow to another capillary structure by using a microstructure layer in a region that overlaps the overlapping surface of the capillary structure. This further implements timely return of the liquid-phase working medium to the evaporation region.

In a possible implementation of the first aspect, in the vapor chamber, the accommodating cavity further includes an evaporation region, a second region of the evaporation region is provided with the microstructure layer, and the second region is a region of the evaporation region other than a region connected to the capillary structure.

In other words, in this implementation of this application, the microstructure layer is provided in the second region in the evaporation region, so that the liquid phase can be distributed more evenly in the evaporation region, temperature uniformity of the vapor chamber is further improved, and a hot spot is further eliminated.

In a possible implementation of the first aspect, in the vapor chamber, the microstructure layer guides the liquid-phase working medium to the capillary structure, and the capillary structure guides the liquid-phase working medium to the evaporation region.

In a possible implementation of the first aspect, in the vapor chamber, the first plate cover, the second plate cover, and the capillary structure are made of at least one of copper, copper alloy, titanium, and titanium alloy, and a forming manner of the microstructure layer includes at least one of high-temperature oxidation processing, high-temperature oxidation processing and high-temperature reduction processing, and electrodeposition.

The vapor chamber has simple forming process, convenient operation, low preparation difficulty, and high economic benefits. When the forming manner of the microstructure layer is high-temperature oxidation and high-temperature reduction, the microstructure layer has a stable structure and a longer service life. When the forming manner of the microstructure layer is electrodeposition, the microstructure layer may present as a dendriform convex structure or a geometrically arranged microcolumn.

In a possible implementation of the first aspect, in the vapor chamber, the capillary structure is a porous structure, and the capillary structure is made of at least one of copper mesh, copper wire, copper powder, and foamed copper. The working medium may be any one of water, methanol, acetone, and liquid ammonia, and the water may be deionized water.

In a possible implementation of the first aspect, in the vapor chamber, the second overlapping surface of the capillary structure is fastened to the first plate cover, and the first overlapping surface of the capillary structure abuts on the second plate cover. Alternatively, the first overlapping surface and the second overlapping surface of the capillary structure are fastened to the first plate cover and the second plate cover respectively.

In other words, in this implementation of this application, the first overlapping surface of the capillary structure abuts on the second plate cover, and a deformation quantity between the first plate cover, the second plate cover, and the capillary structure in thermal expansion and contraction of the vapor chamber is reserved. This avoids deformation of the first plate cover and the second plate cover in the vapor chamber due to pulling by the capillary structure, improves stability of the vapor chamber, and prolongs a service life of the vapor chamber.

A second aspect of this application provides a circuit module. The circuit module specifically includes any one of the vapor chambers according to the first aspect or the possible implementations of the first aspect, a circuit board, and an electronic component mounted on the circuit board. The electronic component is a heat source. A first plate cover abuts on a surface of the electronic component through a heat conductive surface.

The foregoing circuit module, by using any one of the vapor chambers according to the first aspect or the possible implementations of the first aspect, can implement timely heat conduction for the heat source, improve performance of the circuit module, and prolong a service life of the circuit module.

A third aspect of this application provides an electronic device, where the electronic device specifically includes any circuit module in the second aspect.

A fourth aspect of this application provides a method for forming a vapor chamber. The method for forming a vapor chamber includes: assembling a first cover body and a capillary raw material, performing high-temperature oxidation processing on the assembled first cover body and capillary raw material to obtain a first semi-finished product having an oxide surface and a capillary semi-finished product having an oxide surface, and performing high-temperature oxidation processing on a second semi-finished product to obtain a second semi-finished product having an oxide surface; performing high-temperature reduction processing on the first semi-finished product, the second semi-finished product, and the capillary semi-finished product to obtain a first plate cover, a second plate cover, a capillary structure, and a microstructure layer; and assembling the first plate cover and the second plate cover to form a sealed accommodating cavity, where the capillary structure is located in the accommodating cavity. Through the high-temperature reduction processing, an oxide skin is reduced, and the first semi-finished product and the capillary semi-finished product are sintered, to fasten the first plate cover 100 to the capillary structure.

The first cover body is an initial raw material of the first plate cover, a second cover body is an initial raw material of the second plate cover, and the capillary raw material is an initial raw material of the capillary structure.

In the foregoing method for forming a vapor chamber, high-temperature oxidation processing is performed on the assembled first cover body and capillary raw material, and high-temperature oxidation processing is performed on the second semi-finished product, so that copper oxide is formed on surfaces of the first cover body, the second cover body, and the capillary raw material. High-temperature reduction processing is performed on the first semi-finished product, the second semi-finished product, and the capillary semi-finished product, to reduce the copper oxide to copper. This improves stability of the microstructure layer in the vapor chamber, and effectively avoids deterioration of thermal performance of the vapor chamber.

In a possible implementation of the fourth aspect, in the method for forming a vapor chamber, process parameters of the high-temperature oxidation processing include: placing in a gas atmosphere of oxygen, oxygen-nitrogen mixed gas, or air, and heating for 10 min to 5 h at a 300-600°C temperature.

For example, the heating temperature may be any one of 300°C, 350°C, 400°C, 450°C, 500°C, 550°C, and 600°C. A heat preservation time may be any one of 10 min, 20 min, 30 min, 40 min, 50 min, 1h, 2h, 3h, 4h, and 5h.

In a possible implementation of the fourth aspect, in the method for forming a vapor chamber, the high-temperature reduction processing includes: placing in a nitrogen-hydrogen mixed gas atmosphere, and heating for 10 min to 10 h at a 500-800°C temperature.

For example, the heating temperature may be any one of 500°C, 550°C, 600°C, 650°C, 700°C, 750°C, and 800°C. The heat preservation time may be any one of 10 min, 20 min, 30 min, 40 min, 50 min, 1h, 2h, 3h, 4h, 5h, 6h, 7h, and 8h.

A fifth aspect of this application provides a method for forming a vapor chamber. The method for forming a vapor chamber includes: performing high-temperature oxidation processing on a first cover body and a second cover body to obtain a first semi-finished product having an oxide surface and a second semi-finished product having an oxide surface; and assembling the first semi-finished product and a capillary raw material, performing high-temperature reduction processing on the assembled first semi-finished product and capillary raw material, and the second semi-finished product to obtain a first plate cover, a second plate cover, a capillary structure, and a microstructure layer, and assembling the first plate cover and the second plate cover to form a sealed accommodating cavity, where the capillary structure is located in the accommodating cavity.

According to the method for forming a vapor chamber in this application, a microstructure layer on both an inner surface of the accommodating cavity and a wall surface of capillary pores in the capillary structure can be separately formed based on different process parameters. In addition, through high-temperature thermal reduction, an oxide is reduced, and the first semi-finished product and the capillary raw material are sintered, which simplifies operation steps.

A sixth aspect of this application provides a vapor chamber, where the vapor chamber is formed by using any one of the methods for forming a vapor chamber according to the fourth aspect, the possible implementations of the fourth aspect, or the fifth aspect.

### BRIEF DESCRIPTION OF DRAWINGS

FIG. 1(a) is a three-dimensional diagram of a mobile phone 1 according to some embodiments of this application;
FIG. 1(b) is an exploded view of a mobile phone 1 in a Z-axis direction according to some embodiments of this application;
FIG. 1(c) is a schematic diagram obtained after a mobile phone 1 is cut along an A-A cross section in FIG. 1(a) according to some embodiments of this application;
FIG. 2(a) shows an external view of a vapor chamber 10 and a chip 20 from a Y-axis view according to some embodiments of this application;
FIG. 2(b) is a sectional view of a vapor chamber 10 and a chip 20 along a B-B cross section in FIG. 2(a) according to some embodiments of this application;
FIG. 2(c) is a schematic diagram of regions in a vapor chamber 10 according to some embodiments of this application;
FIG. 2(d) is a schematic diagram of a condensation region 13 and a heat dissipation region 14 in a vapor chamber 10 according to some embodiments of this application;
FIG. 3(a) is a sectional view of a vapor chamber 10a along a C-C cross section in FIG. 2(a) according to some embodiments of this application;
FIG. 3(b) is a sectional view of a vapor chamber 10a along a D-D cross section in FIG. 3(a) according to some embodiments of this application;
FIG. 4(a) is a sectional view of a vapor chamber 10b along a C-C cross section in FIG. 2(a) according to some embodiments of this application;
FIG. 4(b) is a sectional view of a vapor chamber 10b and a chip 20 along an E-E cross section in FIG. 4(a) according to some embodiments of this application;
FIG. 4(c) is a sectional view of a vapor chamber 10b along an F-F cross section in FIG. 4(a) according to some embodiments of this application;
FIG. 5(a) is a sectional view of a vapor chamber 10 along a C-C cross section in FIG. 2(a) according to some other embodiments of this application;
FIG. 5(b) is a sectional view of a vapor chamber 10 and a chip 20 along a G-G cross section in FIG. 5(a) according to some other embodiments of this application;
FIG. 5(c) is a sectional view of a vapor chamber 10 and a chip 20 along an H-H cross section in FIG. 5(a) according to some other embodiments of this application;
FIG. 5(d) shows a capillary structure 400 in FIG. 5(c);
FIG. 6(a) is a partial enlarged view of a vapor chamber 10 in an S₁ region in FIG. 5(c) according to some embodiments of this application, where a working medium is condensed into a droplet;
FIG. 6(b) is a partial enlarged view of a vapor chamber 10 in an S₁ region in FIG. 5(c) according to some embodiments of this application, where a return flow of a droplet is shown;
FIG. 7(a) is a partial enlarged view of a vapor chamber 10 in an S₂ region in FIG. 5(c) according to some embodiments of this application, where a working medium is condensed into a droplet;
FIG. 7(b) is a partial enlarged view of a vapor chamber 10 in an S₂ region in FIG. 5(c) according to some embodiments of this application, where a return flow of a droplet is shown;
FIG. 8(a) shows a micrograph of a microstructure 510a in a microstructure layer 500a on an inner surface of an accommodating cavity in a vapor chamber 10 according to some embodiments of this application;
FIG. 8(b) shows a micrograph of a microstructure 510b in a microstructure layer 500b on an inner surface of an accommodating cavity in a vapor chamber 10 according to some other embodiments of this application;
FIG. 8(c) shows a micrograph of an inner surface of an accommodating cavity in a vapor chamber 10b according to some other embodiments of this application;
FIG. 9(a) is a partial enlarged view of a vapor chamber 10 in an S₃ region in FIG. 5(c) according to some embodiments of this application;
FIG. 9(b) is a partial enlarged view of a vapor chamber 10 in an S₃₁ region in FIG. 9(a) according to some embodiments of this application;
FIG. 9(c) is a partial enlarged view of a vapor chamber 10 in an S₃₁ region in FIG. 9(a) according to some other embodiments of this application;
FIG. 10(a) is a partial enlarged view of a vapor chamber 10 in an S₄ region in FIG. 5(c) according to some embodiments of this application;
FIG. 10(b) is a partial enlarged view of a vapor chamber 10 in an S₄ region in FIG. 5(c) according to some other embodiments of this application;
FIG. 11(a) shows a micrograph of a microstructure 510c in a microstructure layer 500c on a capillary structure 400 in a vapor chamber 10 according to some embodiments of this application;
FIG. 11(b) shows a micrograph of a microstructure 510d in a microstructure layer 500d on a capillary structure 400 in a vapor chamber 10 according to some other embodiments of this application;
FIG. 11(c) shows a micrograph of a surface of a capillary structure 400 in a vapor chamber 10b according to some other embodiments of this application;
FIG. 12(a) is a bottom view of a vapor chamber 10 according to some embodiments of this application;
FIG. 12(b) is a bottom view of a vapor chamber 10 according to some embodiments of this application, where a first plate cover 100 is removed;
FIG. 12(c) is a bottom view of a vapor chamber 10b according to some embodiments of this application, where a first plate cover 100b is removed;
FIG. 13(a) is a top view of a vapor chamber 10 according to some embodiments of this application, where a position of a chip 20 is further shown;
FIG. 13(b) is a sectional view of a vapor chamber 10 along an I-I cross section in FIG. 13 (a);
FIG. 14(a) is a sectional view of a vapor chamber 10a along a C-C cross section in FIG. 2(a) according to some other embodiments of this application;
FIG. 14(b) is a sectional view of a vapor chamber 10a along a J-J cross section in FIG. 14(a) according to some other embodiments of this application;
FIG. 15 is a flowchart of forming a vapor chamber 10 according to some embodiments of this application;
FIG. 16 is a flowchart of forming a vapor chamber 10 according to some other embodiments of this application;
FIG. 17(a) is a process diagram of forming a vapor chamber 10 according to some embodiments of this application; and
FIG. 17(b) is a process diagram of forming a vapor chamber 10b according to some other embodiments of this application.

### Reference numerals:

10a: vapor chamber; 11a: heat conductive region; 12a: evaporation region; 13a: condensation region; and 14a: heat dissipation region;
100a: first plate cover; 200a: second plate cover; 300a: accommodating cavity; 400a: capillary structure; 500a: microstructure layer; and 600a: support column;
10b: vapor chamber; 11b: heat conductive region; 12b: evaporation region; 13b: condensation region; 14b: heat dissipation region; 100b: first plate cover; 200b: second plate cover; 300b: accommodating cavity; and 400b: capillary structure;
10: vapor chamber; 11: heat conductive region; 12: evaporation region; 13: condensation region; and 14: heat dissipation region;
100: first plate cover; 200: second plate cover; 300: accommodating cavity; 400: capillary structure; 500: microstructure layer; 20: electronic component; 21: abutted surface; 30: circuit board; 40: display; 50: graphite layer; 60: middle frame; 70: rear cover; 80: back adhesive; 90: thermal conductive gel.

### DESCRIPTION OF EMBODIMENTS

To make the objectives, technical solutions, and advantages of this application clearer, the following further describes implementations of this application in detail with reference to the accompanying drawings.

This application provides an electronic device. The electronic device includes at least one group of circuit modules, and the circuit module includes a vapor chamber, an electronic component, and a circuit board. The electronic component is mounted on the circuit board, and the electronic component has an abutted surface.

It may be understood that the electronic device may be any one of electronic devices that have an electronic component with heat consumption, such as a mobile phone, a tablet computer, a watch, an e-reader, a notebook computer, a vehicle-mounted device, a web television, and a wearable device. The electronic component may be any one of components such as an application processor (Multimedia Application Processor, MAP), a radio frequency amplifier (Radio Frequency Amplifier, RFA), a power amplifier (Power Amplifier, PA), a power management chip (Power Management IC, PMIC), a chip (for example, a system on chip (System on Chip, SOC)), a central processing unit (Central Processing Unit/Processor, CPU), and a power supply.

For ease of description, the following describes the solution by using an example in which the electronic device is a mobile phone, and the electronic component is a chip with high heat generation and slow heat dissipation.

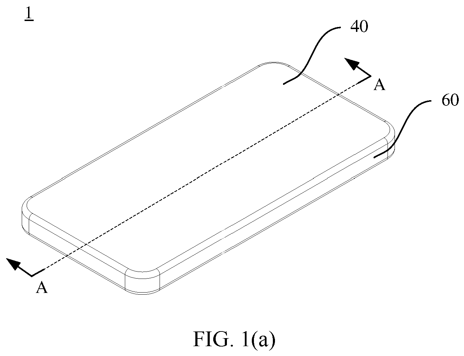

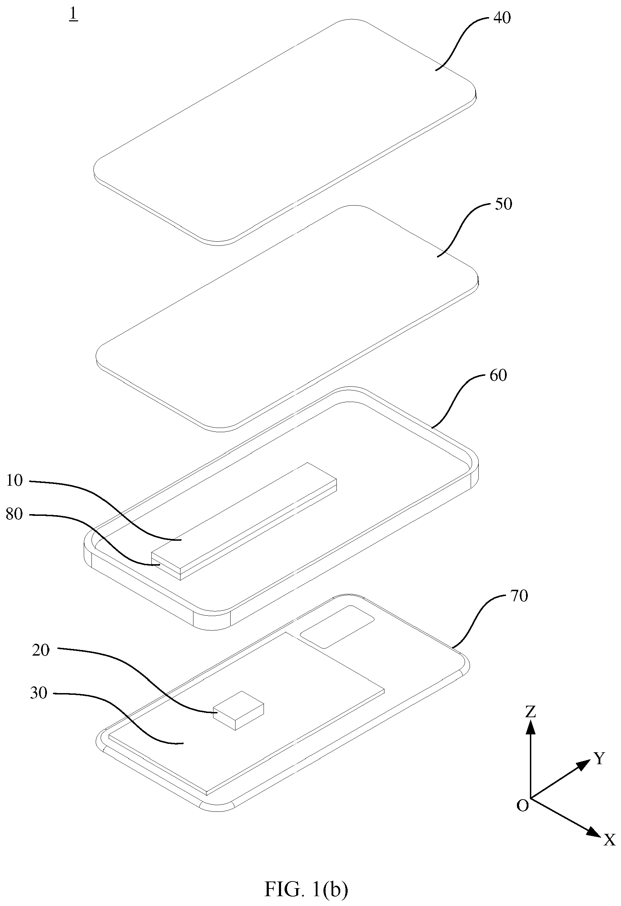

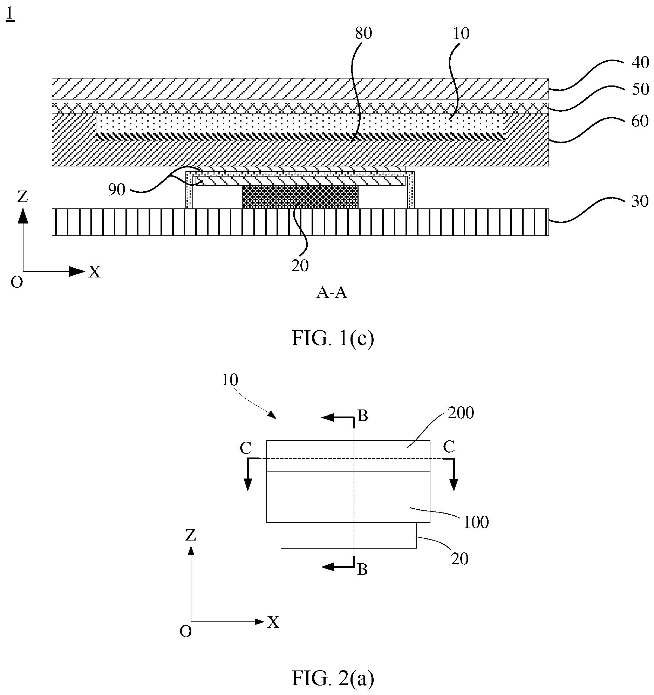

FIG. 1(a) is a three-dimensional diagram of a mobile phone 1 according to some embodiments of this application. FIG. 1(b) is an exploded view of the mobile phone 1 in a Z-axis direction according to some embodiments of this application. FIG. 1(c) is a schematic diagram obtained after the mobile phone 1 is cut along an A-A cross section in FIG. 1(a) according to some embodiments of this application.

It can be learned from FIG. 1(a) to FIG. 1(c) that, this application provides a mobile phone 1. The mobile phone 1 includes a vapor chamber 10, a chip 20, a circuit board 30, a display 40, a graphite layer 50, a middle frame 60, and a rear cover 70. The chip 20 and the vapor chamber 10 are arranged along an overlapping direction. The overlapping direction is a direction in which the vapor chamber 10 and a heat source are stacked, for example, a Z-axis direction in FIG. 1(b). A lower surface of the vapor chamber 10 adheres to the middle frame 60 through a back adhesive 80, and an upper surface of the vapor chamber 10 is connected to a surface of the graphite layer 50. The circuit board 30 is mounted on the rear cover 70. The chip 20 is mounted on a surface that is of the rear cover 70 and that faces away from the circuit board 30. The display 40, the graphite layer 50, the middle frame 60, and the rear cover 70 are sequentially stacked. A side that is of the middle frame 60 and that is adhered by the vapor chamber 10 faces the graphite layer 50. A side that is of the rear cover 70 and that is mounted with the chip 20 faces the middle frame 60. The chip 20 adheres, through a thermal conductive gel 90, to a surface of a side that is of the middle frame 60 and that faces away from the vapor chamber 10. A stacking direction of the vapor chamber 10 and the chip 20 is defined as a thickness direction (as shown in the Z-axis direction in FIG. 1(a) to FIG. 1(c)). It can be understood that, in this application, a thickness of a component other than a microstructure layer is in the thickness direction.

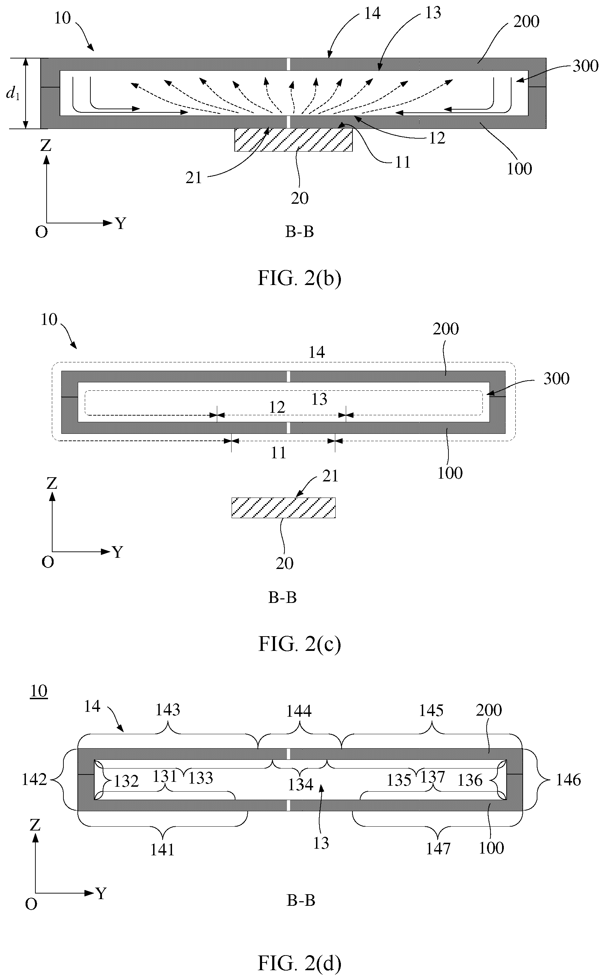

Based on this, heat generated by the chip 20 is transferred to the middle frame 60 through the thermal conductive gel 90, so that the heat is transferred, through the middle frame 60 and the back adhesive 80, from a region (namely, a heat conductive region) that is on the lower surface of the vapor chamber 10 and that is opposite to the chip 20 to the vapor chamber 10, or is directly dissipated from the middle frame 60 to an external environment. Then, heat of the vapor chamber 10 is conducted by using two paths: The vapor chamber 10 dissipates heat to the graphite layer 50 through the upper surface (that is, a part of a heat dissipation region 14 mentioned in FIG. 2(c) below); and the vapor chamber 10 dissipates, through a side surface and a region other than a conduction surface (that is, another part of the heat dissipation region 14 mentioned in FIG. 2(c) below), heat to the middle frame 60 disposed around the vapor chamber 10. Finally, the graphite layer 50, the display 40, and the middle frame 60 dissipate heat to the external environment, to complete heat dissipation of the chip 20. The vapor chamber 10 is a pumpless phase-change heat sink component, and can effectively diffuse concentrated heat, thereby eliminating a hot spot and implement temperature uniformity, and playing an important role in heat dissipation performance of the electronic device.

The heat conductive region is an outer surface that is on the vapor chamber 10 and that is connected to the chip 20 when the vapor chamber 10 abuts on the chip 20. For example, the heat conductive region is a projection region of the chip 20 on a surface on a side that is of the vapor chamber 10 and that is close to the chip 20. For another example, the heat conductive region is a projection region, on the surface of the side that is of the vapor chamber 10 and that is close to the chip 20, of the thermal conductive gel 90 used to fasten the chip 20.

In some implementations, as shown in FIG. 1(c), the mobile phone 1 further includes a protective cover (not marked), where the protective cover is disposed outside the chip 20 on the circuit board 30. The chip 20 is connected to the protective cover through a thermal conductive gel 90, the protective cover is connected to the middle frame 60 through another thermal conductive gel, and heat is transferred from the chip 20 to the vapor chamber 10 through the thermal conductive gel 90, the protective cover, the another thermal conductive gel 90, and the middle frame 60.

In some other alternative implementations, a through hole corresponding to the chip 20 is provided on the middle frame 60, and the chip 20 passes through the through hole and is in contact with the vapor chamber 10 through the thermal conductive gel 90, or the vapor chamber 10 passes through the through hole and abuts on a surface of the chip 20.

In some other alternative implementations, the circuit board 30 (or the rear cover) is combined with the vapor chamber 10, so that the chip 20 abuts on the vapor chamber 10. For example, the middle frame 60 and the circuit board 30 (or the rear cover) are provided with a mounting hole adapted to a fastening member. The fastening member and the mounting hole are used to implement detachable connection between the middle frame 60 and the circuit board 30 (or the rear cover). The fastening member may be a fastening screw, a column-shaped spring, an elastic element, or the like.

For ease of understanding, the following provides description by using an example in which a through hole corresponding to the chip 20 is provided on the middle frame 60, and the chip 20 and the vapor chamber 10 overlap and are in contact along the overlapping direction.

Before a solution of reducing a thickness of the vapor chamber 10 is described, a specific structure and a working principle of the vapor chamber 10 further need to be described first.

FIG. 2(a) shows an external view of a vapor chamber 10 and a chip 20 from a Y-axis view according to some embodiments of this application. FIG. 2(b) is a sectional view of the vapor chamber 10 and the chip 20 along a B-B cross section in FIG. 2(a) according to some embodiments of this application. FIG. 2(c) is a schematic diagram of regions in the vapor chamber 10 according to some embodiments of this application. FIG. 2(d) is a schematic diagram of a condensation region 13 and a heat dissipation region 14 in the vapor chamber 10 according to some embodiments of this application.

It can be learned from FIG. 2(a) to FIG. 2(c) that, in the description of this embodiment of this application, in an X-axis direction, a size of the chip 20 is approximately the same as a size of the vapor chamber 10. In a Y-axis direction, the size of the chip 20 is far less than the size of the vapor chamber 10. It may be understood that, in another embodiment, the size of the chip 20 is far less than the size of the vapor chamber 10 in both the X-axis direction and the Y-axis direction. Details are not described herein.

As shown in FIG. 2(b), the vapor chamber 10 includes a first plate cover 100, a second plate cover 200, a sealed accommodating cavity (not shown in the figure) jointly formed by the first plate cover 100 and the second plate cover 200, and at least one capillary structure (not shown in the figure) located in the accommodating cavity. The at least one capillary structure, the first plate cover 100, and the second plate cover 200 jointly form a vapor channel 300.

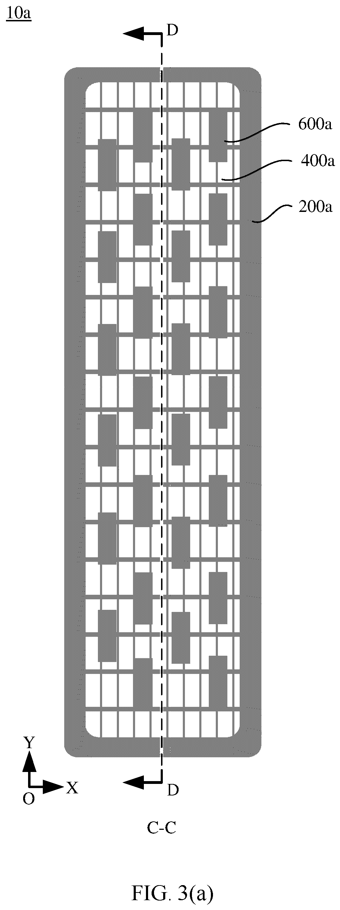

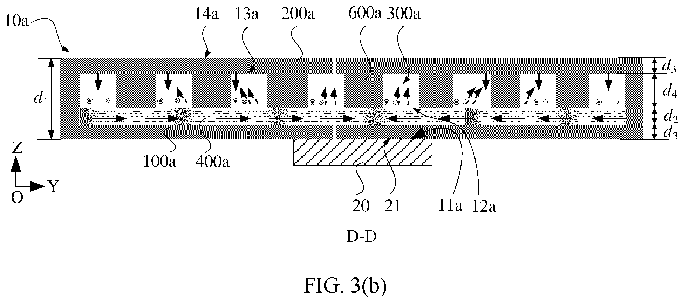

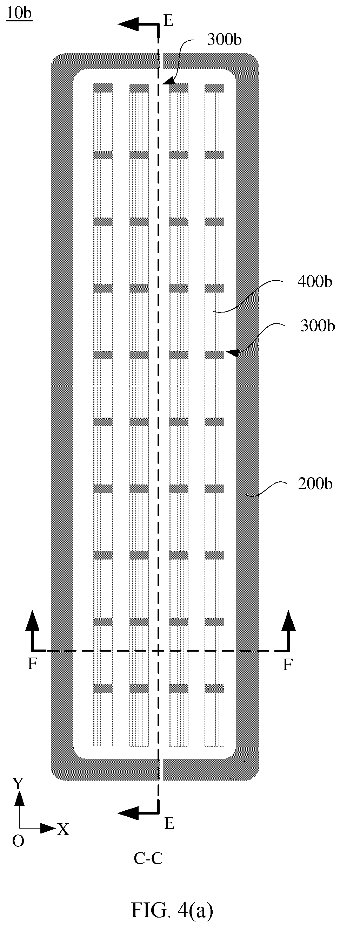

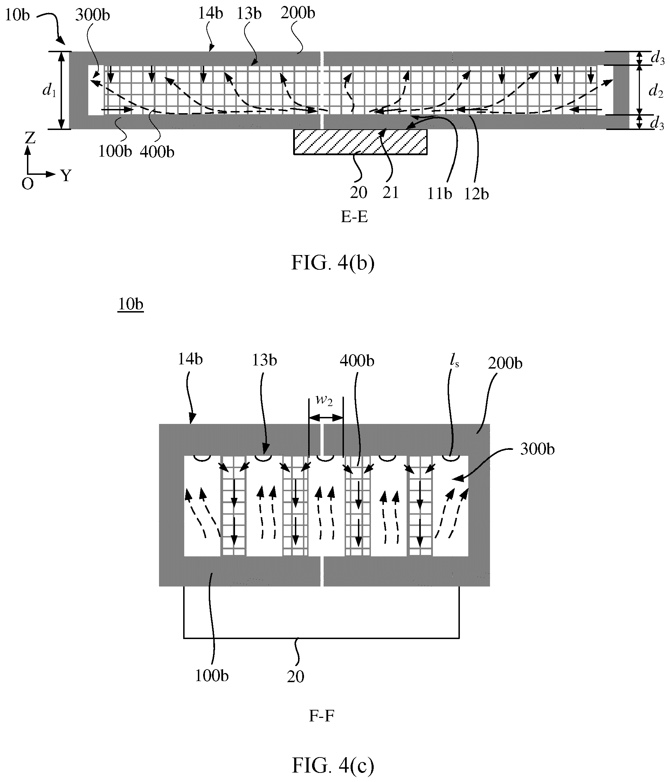

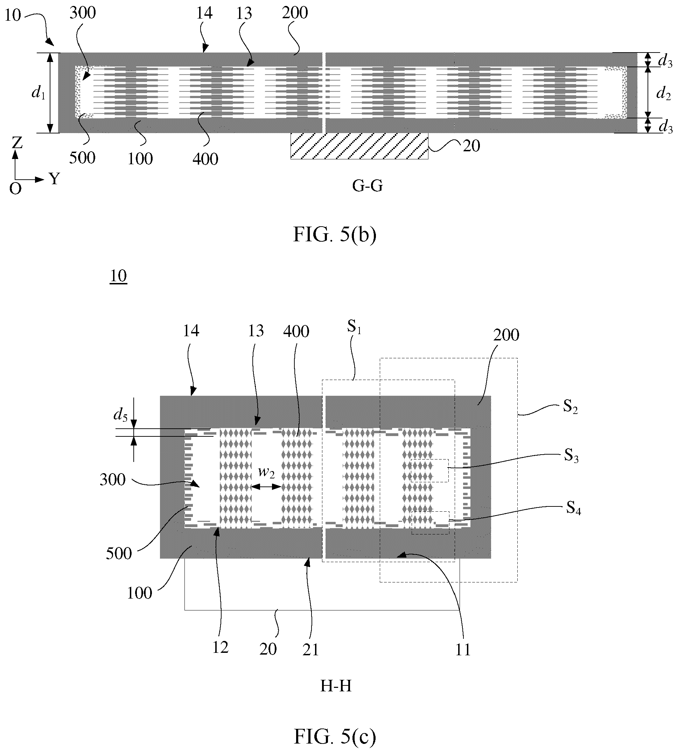

As shown in FIG. 2(c), the vapor chamber 10 includes a heat conductive region 11, an evaporation region 12, the condensation region 13, and the heat dissipation region 14. The evaporation region 12 is a partial region that is on an inner surface of the accommodating cavity and that is close to the chip 20. In the partial region, a liquid-phase working medium can evaporate into a gas phase when the chip 20 is heated. For example, the evaporation region 12 is an orthographic projection that is of the heat conductive region 11 on the inner surface of the accommodating cavity and that is close to the heat conductive region 11. For another example, the evaporation region 12 is an orthographic projection that is of the heat conductive region 11 on the inner surface of the accommodating cavity and that is close to the heat conductive region 11, and a surrounding region connected to the orthographic projection. It may be understood that, when another structure (for example, a capillary structure) is further provided on the inner surface of the accommodating cavity that is relatively close to the chip 20, the evaporation region 12 further includes a surface of the another structure (for example, a surface of the capillary structure). A surface in the evaporation region 12 can be used as an evaporation surface for evaporating the liquid-phase working medium. For example, the evaporation surface may be an inner surface, in the evaporation region 12, of the accommodating cavity corresponding to the vapor channel 300, or the evaporation surface may be a surface, in the evaporation region 12, of a capillary structure (for details, refer to a capillary structure 400a in FIG. 3(b), a capillary structure 400b in FIG. 4(c), and a capillary structure 400 in FIG. 5(c) below).

The condensation region 13 is a part of region on the inner surface of the accommodating cavity that is away from the chip 20, and in the part of region, a gas-phase working medium can be condensed into a liquid droplet. For example, the condensation region 13 is a region other than the evaporation region 12 on the inner surface of the accommodating cavity. It may be understood that, when another structure (for example, a capillary structure) is further provided on the inner surface of the accommodating cavity that is relatively far away from the chip 20, the condensation region 13 further includes a surface of another structure (for example, a support column) that is opposite to the chip. For example, the condensation region 13 may be the inner surface of the accommodating cavity corresponding to the vapor channel 300, and the condensation region 13 may alternatively be the surface of the support column.

The heat dissipation region 14 is an outer surface, on the vapor chamber 10, that needs to dissipate heat to the outside because the chip 20 generates heat. For example, the heat dissipation region 14 is an outer surface other than the heat conductive region 11 on the vapor chamber 10. Surfaces corresponding to the evaporation region 12 and the condensation region 13 are not specifically limited in this application.

It can be learned from FIG. 2(d) that in some implementations, the condensation region 13 includes a first condensation region 131, a second condensation region 132, a third condensation region 133, a fourth condensation region 134, a fifth condensation region 135, a sixth condensation region 136, and a seventh condensation region 137 that are sequentially connected. The first condensation region 131 and the seventh condensation region 137 are distributed on an inner bottom surface of the first plate cover 100, and are located on two sides of the evaporation region 12. The second condensation region 132 and the sixth condensation region 136 are inner wall surfaces of the accommodating cavity. The third condensation region 133 is located right above the first condensation region 131, and a projection of the first condensation region 131 on an inner top surface of the second plate cover 200 falls into the third condensation region 133. The fifth condensation region 135 is located right above the seventh condensation region 137, and a projection of the seventh condensation region 137 on the inner top surface of the second plate cover 200 falls into the fifth condensation region 135. The fourth condensation region 134 is located right above the evaporation region 12, and a projection of the fourth condensation region 134 on the inner bottom surface of the first plate cover 100 falls into the evaporation region 12. Droplets are more likely to appear in a region far away from the chip 20, and less likely to appear in a region close to the chip 20.

It can be learned from FIG. 2(d) that in some implementations, the heat dissipation region 14 includes a first heat dissipation region 141, a second heat dissipation region 142, a third heat dissipation region 143, a fourth heat dissipation region 144, a fifth heat dissipation region 145, a sixth heat dissipation region 146, and a seventh heat dissipation region 147 that are sequentially connected. The first heat dissipation region 141 and the seventh heat dissipation region 147 are distributed on an outer bottom surface of the first plate cover 100, and are located on two sides of the heat conductive region 11. The second heat dissipation region 142 and the sixth heat dissipation region 146 are outer wall surfaces of the accommodating cavity. The third heat dissipation region 143 is located right above the first heat dissipation region 141, and a projection of the first heat dissipation region 141 on an outer top surface of the second plate cover 200 falls into the third heat dissipation region 143. The fifth heat dissipation region 145 is located right above the seventh heat dissipation region 147, and a projection of the seventh heat dissipation region 147 on the outer top surface of the second plate cover 200 falls into the fifth heat dissipation region 145. The fourth heat dissipation region 144 is located right above the evaporation region 12, and a projection of the fourth heat dissipation region 144 on the outer bottom surface of the first plate cover 100 falls into the heat conductive region 11.

In addition, the chip 20 has an abutted surface 21 that is configured to abut on the heat conductive region 11. An orthographic projection of the abutted surface 21 in a plane on which the heat conductive region 11 is located falls into the heat conductive region 11.

When the chip 20 starts to generate heat, heat generated by the chip 20 is transferred to the vapor chamber 10 through heat conduction between the abutted surface 21 and the heat conductive region 11. The liquid-phase working medium in the evaporation region 12 starts to undergo an evaporation phase change in a low vacuum environment, changes from a liquid phase to a gas phase, and takes away heat, on the vapor chamber 10, close to the heat conductive region 11 and the evaporation region 12. Then, the gas-phase working medium rapidly diffuses to the entire vapor channel 300. When the gas-phase working medium is in contact with the low-temperature condensation region 13, the gas-phase working medium is condensed into a liquid-phase working medium to release heat, and the heat is transferred to the heat dissipation region 14 of the vapor chamber 10 through the condensation region 13, so that centralized heat of the chip 20 is rapidly diffused to the entire heat dissipation region 14 of the vapor chamber 10. Finally, the liquid-phase working medium in the condensation region 13 returns to the evaporation region 12 of the vapor chamber 10 under the action of a capillary force of a capillary structure (for details, refer to the capillary structure 400a in FIG. 3(b), the capillary structure 400b in FIG. 4(c), and the capillary structure 400 in FIG. 5(c) below). The foregoing cycle process is repeatedly performed in the vapor channel 300 and the capillary structure 400. In this way, heat generated by the chip 20 can be carried out to the external environment, a hot spot of the chip 20 is eliminated, and the chip 20 is cooled. It may be understood that, in this application, a solid line with an arrow in the capillary structure 400 represents a flow direction of the liquid-phase working medium, and a dashed line with an arrow in the vapor channel 300 represents a diffusion direction of the gas-phase working medium in the vapor channel 300.

Based on this, as a two-phase heat transfer device, the vapor chamber 10 can effectively and rapidly diffuse concentrated heat, and has high effective thermal conductivity. For example, when the vapor chamber 10 is made of copper, effective thermal conductivity of the vapor chamber 10 is 10 to 20 times effective thermal conductivity of pure copper. The vapor chamber 10 has excellent thermal conduction and temperature uniformity performance, and is an effective solution to a heat dissipation problem of a terminal electronic device.

To implement heat dissipation of the chip 20 by the vapor chamber 10, the following several vapor chambers 10 are mainly included currently. The following provides description with reference to specific application scenarios.

In some scenarios, to meet requirements for thinness and lightweight of an electronic device, as shown in FIG. 3(a) and FIG. 3(b), this application provides a vapor chamber 10a. The vapor chamber 10a reduces a thickness of the capillary structure 400a and an overall thickness of the vapor chamber 10a, to implement thinness and lightweight of the electronic device. FIG. 3(a) is a sectional view of the vapor chamber 10a along a C-C cross section in FIG. 2(a) according to some embodiments of this application. FIG. 3(b) is a sectional view of the vapor chamber 10a along a D-D cross section in FIG. 3(a) according to some embodiments of this application.

It can be learned from FIG. 3(a) and FIG. 3(b) that the vapor chamber 10a includes a first plate cover 100a, a second plate cover 200a, a capillary structure 400a, and a support column 600a. The capillary structure 400a is laid on an inner surface, on the first plate cover 100a, that includes an evaporation region 12a, and two ends of the support column 600a are respectively connected to the second plate cover 200a and the capillary structure 400a. The first plate cover 100a, the second plate cover 200a, the capillary structure 400a, and the support column 600a jointly form a vapor channel 300a, and a liquid-phase working medium is located in the capillary structure 400a. In a use state, an abutted surface 21 of the chip 20 abuts on a heat conductive surface 11a of the vapor chamber 10a.

When the chip 20 is heated, the liquid-phase working medium evaporates from an upper surface of the capillary structure 400a to vapor, and diffuses upward to the vapor channel 300a between the support columns 600a. Then, the vapor is condensed into a liquid phase at a lowertemperature condensation region 13a. Finally, the liquid-phase working medium in the condensation region 13a is in contact with the capillary structure 400a, and returns to the evaporation region 12a of the vapor chamber 10a under the action of a capillary force of the capillary structure 400a. The foregoing cycle process is repeatedly performed in the vapor channel 300a and the capillary structure 400a, so that the chip 20 is cooled.

Currently, a manner of reducing a thickness of the vapor chamber 10a includes: reducing a thickness d₄ of the support column 600a, reducing a thickness d₃ of the copper plate 200a, reducing a thickness d₃ of the copper plate 100a, and reducing a thickness of the capillary structure 400a. A reduced thickness of the support column 500a will lead to a decreased height of the vapor channel 300a. The height of the vapor channel 300a is a size of the vapor channel 300a in a thickness direction. Because vapor resistance is inversely proportional to the height of the vapor channel 300a, the vapor resistance increases sharply as the height of the vapor channel 300a decreases. The vapor resistance is proportional to a vapor temperature difference. As the vapor resistance increases, the vapor temperature difference increases, and temperature uniformity of the vapor chamber 10a deteriorates. In addition, to ensure stability of a structure of the vapor chamber 10a, the first plate cover 100a, the second plate cover 200a, and the support column 500a need to have a specific thickness. For example, both the first plate cover 100a and the second plate cover 200a are copper plates with a minimum thickness of 0.04 mm, and a minimum thickness of the support column 500a is 0.1 mm. In addition, the capillary structure 400a also has a minimum thickness due to a structural characteristic of the capillary structure 400a. For example, when the capillary structure 400a is made of copper mesh, a minimum thickness of the copper mesh is 0.06 mm.

In a process of realizing thinness and lightweight of the electronic device, when the thickness of the capillary structure 400a is decreased to decrease the thickness of the vapor chamber 10a, the decrease of the thickness of the vapor chamber 10a is relatively limited. For example, a minimum thickness of the vapor chamber 10a is about 0.35 mm, and it is difficult to achieve a smaller thickness than 0.35 mm. Further, when the thickness of the capillary structure 400a decreases, flow resistance of the liquid-phase working medium increases. Consequently, it is difficult to supplement the liquid-phase working medium in the evaporation region 12a of the vapor chamber 10a, which causes temperature uniformity performance of the vapor chamber 10a to decrease.

In some other scenarios, to reduce the thickness of the vapor chamber 10a while ensuring temperature uniformity performance, as shown in FIG. 4(a) and FIG. 4(b), this application further provides a vapor chamber 10b. The vapor chamber 10b does not have a support column, and a first plate cover 100b and a second plate cover 200b are supported through a capillary structure 400b, so that the vapor chamber 10b has a relatively small size in a thickness direction. FIG. 4(a) is a sectional view of the vapor chamber 10b along a C-C cross section in FIG. 2(a) according to some embodiments of this application. FIG. 4(b) is a sectional view of the vapor chamber 10b and the chip 20 along an E-E cross section in FIG. 4(a) according to some embodiments of this application. FIG. 4(c) is a sectional view of the vapor chamber 10b and the chip 20 along an F-F cross section in FIG. 4(a) according to some embodiments of this application.

It may be understood that the E-E cross section is an example of a cross section that passes through a vapor channel 300b. The F-F cross section is an example of a cross section whose projection falls into a condensation region 13b. However, generally, a working medium is likely to be condensed into a liquid droplet at a position far away from the chip 20. Therefore, the following describes a process of condensation and return of the liquid droplet by using an example in which the vapor chamber is located on a side of the chip 20 and the F-F cross section is a cross section at a position far away from the chip 20 in FIG. 4(a).

It can be learned from FIG. 4(a) and FIG. 4(b) that the vapor chamber 10b includes the first plate cover 100b, the second plate cover 200b, and the capillary structure 400b. The first plate cover 100b and the second plate cover 200b jointly form an accommodating cavity. The capillary structure 400b is provided in the accommodating cavity. The vapor channel 300b is formed around the capillary structure 400b, and the capillary structure 400b is filled with the working medium. Capillary structures 400b are in a shape of a long strip, and are arranged at intervals in the accommodating cavity in parallel. Two opposite surfaces of the capillary structure 400b are respectively connected to the first plate cover 100b and the second plate cover 200b, and support the first plate cover 100b and the second plate cover 200b in the thickness direction.

In this application, compared with the vapor chamber 10a, the vapor chamber 10b does not have a support column, and uses the capillary structure 400b to support the first plate cover 100b and the second plate cover 200b, thereby saving thickness space occupied by the support column. Therefore, the vapor chamber 10b can maximize a thickness of the vapor channel 300b, and help reduce vapor resistance.

However, it can be learned from FIG. 4(a) to FIG. 4(c) that in the vapor chamber 10b, after the liquid-phase working medium evaporates into vapor in an evaporation region 12b, the vapor diffuses in the vapor channel 300b, and is condensed into a small liquid droplet *lₛ* in a condensation region 13b. Due to lack of a driving force and a small size, the small liquid droplet *lₛ* cannot be in contact with the capillary structures 400b on two sides. Therefore, the small liquid droplet *lₛ* between the vapor channels 300b needs to accumulate to a specific volume, and can be in contact with the capillary structures 400b on the two sides of the vapor channels 300b only after the small liquid droplet *lₛ* becomes a large liquid droplet (not shown in the figure). Then, the large droplet is absorbed by the capillary structure 400b, and returns to the evaporation region 12b shown in FIG. 4(b).

The liquid-phase working medium needs to gather to become a large liquid droplet to be in contact with the capillary structure 400b or to drop, that is, in the vapor chamber 10b, it is highly possible that the liquid-phase working medium cannot return to the capillary structure 400b in time. As a result, the liquid-phase working medium does not return to the evaporation region 12b in time, and consequently, the liquid-phase working medium is not filled in time in the evaporation region 12b. This causes a temperature difference of the vapor chamber 10b to increase, and performance to deteriorate. In addition, during storage and transportation, liquid droplets gathered in the vapor chamber 10b are in a low-temperature environment, and may freeze and bulge, resulting in deformation of the vapor chamber 10b.

It is not difficult to understand that, because a thickness of the first plate cover 100b and a thickness of the second plate cover 200b are relatively thin (for example, the thickness of the first plate cover 100b and the thickness of the second plate cover 200b are 0.04 mm), freezing and bulging of droplets in the vapor chamber 10b may likely to cause a bump on a surface of the vapor chamber 10b. This may cause the following: A heat conductive surface of the vapor chamber 10b does not tightly abut on an abutted surface of the chip 20; a heat dissipation surface of the vapor chamber 10b does not tightly abut on a surrounding heat dissipation medium (for example, a graphite layer or a middle frame); and consequently, a heat dissipation effect of the vapor chamber 10b deteriorates.

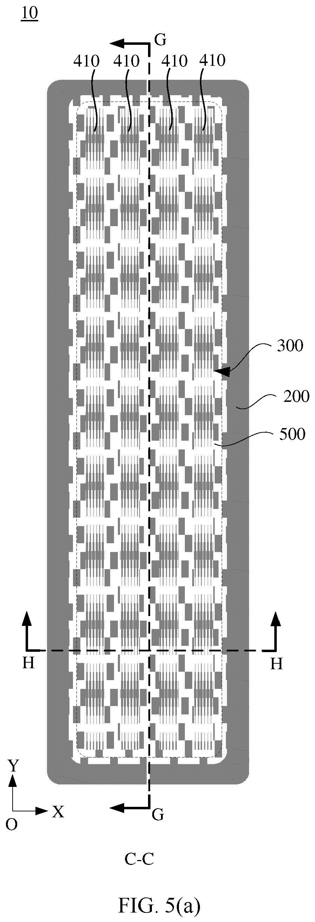

To resolve a problem that the liquid-phase working medium in the vapor chamber (for example, the vapor chamber 10b) is less likely to return to the evaporation region, this application provides a vapor chamber 10. As shown in FIG. 5(a) and FIG. 5(b), in the vapor chamber 10, a microstructure layer 500 is introduced to both an inner surface of an accommodating cavity (that is, an inner surface of a first plate cover 100 and an inner surface of a second plate cover 200) and a capillary structure 400. In this way, a liquid-phase working medium in a condensation region 13 is guided through the microstructure layer 500, and then returns to an evaporation region 12.

In some embodiments of this application, a thickness range of the microstructure layer 500 ranges from 0.1 µm to 20 µm. It can be learned from the foregoing that a thickness range of the capillary structure 400 approximately ranges from 0.05 mm to 0.5 mm. A minimum thickness of a support column 600a is 0.1 mm. Therefore, a thickness of the microstructure layer 500 is far less than a size of the support column 600a and a size of the capillary structure 400 in a thickness direction.

With the addition of the microstructure 500 to the inner surface of the accommodating cavity in the vapor chamber 10, wettability of the inner surface of the accommodating cavity is enhanced without changing a structural size of the vapor chamber 10, and a driving force for liquid droplets to return to the capillary structure along the inner surface of the accommodating cavity is improved. In addition, the microstructure layer 500 is introduced to the capillary structure 400, so that capillary performance of the capillary structure 400 is strengthened, and a driving force for the liquid droplets to continue to return along the capillary structure 400 is improved. In conclusion, the vapor chamber 10 can implement timely return of the liquid-phase working medium in the condensation region 13b, and improves a problem that liquid droplets gather in the condensation region 13b in the vapor chamber 10b and are less likely to return to the evaporation region 12b.

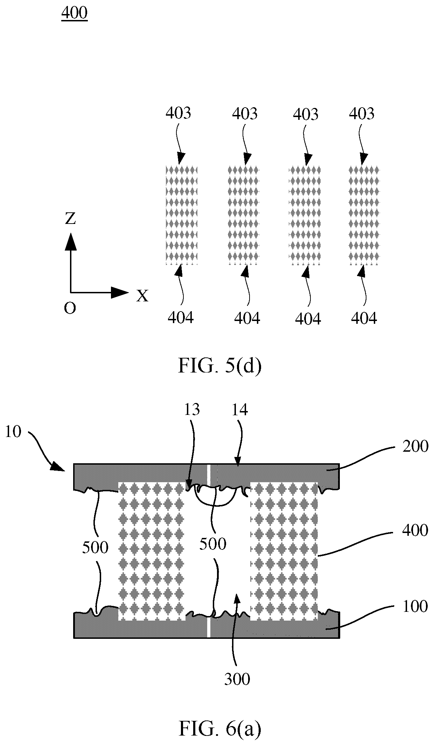

Specifically, FIG. 5(a) is a sectional view of the vapor chamber 10 along a C-C cross section in FIG. 2(a) according to some other embodiments of this application. FIG. 5(b) is a sectional view of the vapor chamber 10 and the chip 20 along a G-G cross section in FIG. 5(a) according to some other embodiments of this application. FIG. 5(c) is a sectional view of the vapor chamber 10 and the chip 20 along an H-H cross section in FIG. 5(a) according to some other embodiments of this application. FIG. 5(d) shows the capillary structure 400 in FIG. 5(c), and identifies a first overlapping surface 403 and a second overlapping surface 404 on the capillary structure 400.

It may be understood that the G-G cross section is an example of a cross section that passes through the vapor channel 300. The H-H cross section is an example of a cross section whose projection falls into the condensation region 13. However, generally, a working medium is likely to be condensed into a liquid droplet at a position far away from the chip 20. With reference to FIG. 5(a) and FIG. 5(b), it is not difficult to understand that the H-H cross section is a cross section at a position away from the chip 20. Therefore, the following describes a process of condensation and return of the liquid droplet by using a structure of the vapor chamber 10 at the H-H cross section as an example.

As shown in FIG. 5(a) and FIG. 5(b), this application provides a vapor chamber 10 configured to be in contact with the chip 20 to cool the chip 20. The contact between the vapor chamber 10 and the chip 20 may be a direct contact, or may be an indirect contact. This is not specifically limited by this application.

The vapor chamber 10 includes the first plate cover 100, the second plate cover 200, the capillary structure 400, and the microstructure layer 500. The first plate cover 100 and the second plate cover 200 are connected to jointly form a sealed accommodating cavity, and the capillary structure 400 is located in the accommodating cavity.

Specifically, it can be learned from FIG. 5(a) to FIG. 5(d) that, the first plate cover 100 and the second plate cover 200 overlap along an overlapping direction, and jointly form the sealed accommodating cavity. A heat conductive surface 11 configured to abut on the heat source is provided on a side that is of the first plate cover 100 and that faces away from the accommodating cavity 300. The capillary structure 400 has a pair of the first overlapping surface 403 and the second overlapping surface 404 that are opposite to each other and perpendicular to the overlapping direction. The first overlapping surface 403 of the capillary structure 400 is connected to the second plate cover 200, and the second overlapping surface 404 of the capillary structure 400 is connected to the first plate cover 100 to support the first plate cover 100 and the second plate cover 200 in the overlapping direction. A microstructure layer 500 is provided on an inner surface of the accommodating cavity 300 and a wall surface of capillary pores in the capillary structure 400. The microstructure layer 500 is configured to guide a liquid-phase working medium in the accommodating cavity in the vapor chamber. For example, between two capillary structures 400, a liquid-phase working medium on the inner surface of the accommodating cavity 300 is guided back to the capillary structure 400 through the microstructure layer 500, and the microstructure layer on the wall surface of capillary pores in the capillary structure 400 continues to guide a liquid-phase working medium that is in the capillary structure 400 and that is close to the first overlapping surface 403 back to a position that is in the capillary structure 400 and that is close to the second overlapping surface 404.

According to condensation and evaporation of the working medium on the inner surface of the accommodating cavity, the inner surface of the accommodating cavity includes the evaporation region 12 and the condensation region 13, where the evaporation region 12 is located on the first plate cover 100. The capillary structure 400 is located in the accommodating cavity, and two opposite surfaces of the capillary structure 400 are respectively connected to the inner surface of the first plate cover 100 and the inner surface of the second plate cover 200, to support the first plate cover 100 and the second plate cover 200 along the thickness direction. The microstructure layer 500 is provided on the inner surface of the accommodating cavity, and the liquid-phase working medium in the condensation region 13 is guided to the evaporation region 12 through the microstructure layer 500. The thickness of the microstructure layer 500 is less than the size of the capillary structure 400 in the thickness direction. The thickness of the microstructure layer 500 is a size (for example, d₃ in FIG. 5(c)) in a direction perpendicular to a plane on which the microstructure layer 500 is laid.

When the first plate cover 100 and the second plate cover 200 are made of copper, the first plate cover 100 and the second plate cover 200 may be connected through diffusion welding, or the first plate cover 100 and the second plate cover 200 are connected through brazing.

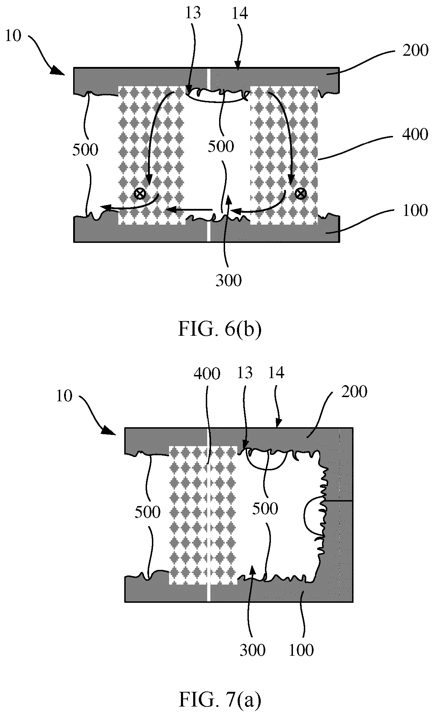

FIG. 6(a) is a partial enlarged view of the vapor chamber 10 in an S₁ region in FIG. 5(c) according to some embodiments of this application, where a working medium is condensed into a droplet. FIG. 6(b) is a partial enlarged view of the vapor chamber 10 in the S₁ region in FIG. 5(c) according to some embodiments of this application, where a return flow of a droplet is shown.

It can be learned from FIG. 6(a) and FIG. 6(b) that the microstructure layer 500 on the inner surface of the accommodating cavity is configured to enhance hydrophilicity and wettability of the inner surface of the accommodating cavity. As shown in FIG. 6(b), the vapor chamber 10 can guide the liquid-phase working medium to the capillary structure 400 in time through the microstructure layer 500, and guide the liquid-phase working medium back to the evaporation region 12 through the capillary structure 400 and the microstructure layer 500 on the first plate cover 100. For example, the liquid-phase working medium flows in a direction inward perpendicular to paper in a region in which the capillary structure 400 is located in FIG. 6(b). Therefore, the vapor chamber 10 in this application can prevent a large quantity of liquid phase liquid-phase working mediums from gathering in the condensation region 13, and supplement liquid phase working medium in the evaporation region 12 in time, to resolve a problem of liquid droplet gathering and delayed return of the liquid-phase working medium.

In some implementations, still refer to FIG. 6(a) and FIG. 6(b). A liquid-phase working medium in the capillary structure 400 (namely, the capillary structure 400 on the right in FIG. 6(b)) close to an edge of the chip 20 can use the microstructure layer 500 between the two capillary structures 400, so that the liquid-phase working medium flows from the capillary structure 400 on the right to the capillary structure 400 on the left.

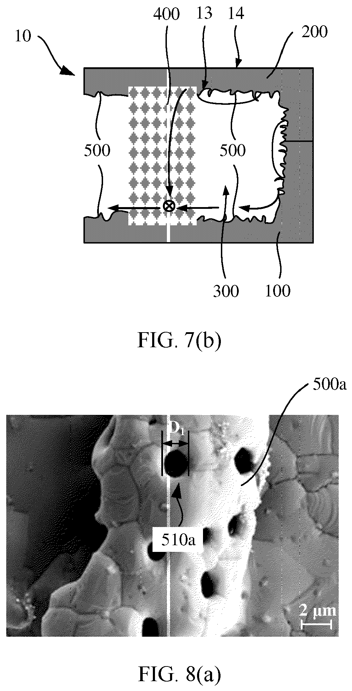

FIG. 7(a) is a partial enlarged view of the vapor chamber 10 in an S₂ region in FIG. 5(c) according to some embodiments of this application, where a working medium is condensed into a droplet. FIG. 7(b) is a partial enlarged view of the vapor chamber 10 in the S₂ region in FIG. 5(c) according to some embodiments of this application, where a return flow of a droplet is shown.

It can be learned from FIG. 7(a) and FIG. 7(b) that the microstructure layer 500 on the inner surface of the accommodating cavity is configured to enhance hydrophilicity and wettability of the inner surface of the accommodating cavity. Therefore, as shown in FIG. 7(b), the vapor chamber 10 can guide, to the capillary structure 400 in time, a liquid-phase working medium close to the capillary structure 400, and guide the liquid-phase working medium back to the evaporation region 12 through the capillary structure 400 and the microstructure layer 500 on the first plate cover 100. In addition, the vapor chamber 10 can further guide, in a case that few liquid droplets gather, a liquid-phase working medium (for example, a liquid-phase working medium at a position relative to the capillary structure 400, for example, a liquid droplet on a right inner wall surface in FIG. 7(b)) away from the capillary structure 400 to a nearby microstructure layer 500 in time, and guide the liquid-phase working medium back to the evaporation region 12 through the microstructure layer 500.

In some implementations, the microstructure layer 500 guides the liquid-phase working medium to the capillary structure 400, and the capillary structure 400 guides the liquid-phase working medium to the evaporation region 12.

In some other alternative implementations, the microstructure layer 500 guides the liquid-phase working medium to a nearby microstructure layer 500, and the nearby microstructure layer 500 guides the liquid-phase working medium to the evaporation region 12.

In some embodiments of this application, the microstructure layer 500 is provided in a region, in the condensation region 13, other than a region connected to the capillary structure 400. It may be understood that, the condensation region 13 is not necessarily completely covered with the microstructure layer 500, provided that the microstructure layer 500 in the condensation region 13 can guide the liquid-phase working medium to a nearby capillary structure 400, or the microstructure layer in the condensation region 13 can guide the liquid-phase working medium to the evaporation region 12. For example, the microstructure layer 500 is a mesh structure covering the condensation region 13 or a parallel distributed structure. This is not specifically limited in this application. The region of the condensation region 13 connected to the capillary structure 400 is described in detail below.

In some embodiments of this application, the microstructure layer 500 is provided in a region, in the evaporation region 12, other than a region connected to the capillary structure 400. It may be understood that, the evaporation region 12 is not necessarily completely covered with the microstructure layer 500, provided that the microstructure layer 500 in the evaporation region 12 can guide the liquid-phase working medium to a nearby capillary structure 400, or the microstructure layer in the evaporation region 12 can guide the liquid-phase working medium to the evaporation region 12. For example, the microstructure layer 500 is a mesh structure covering the evaporation region 12 or a parallel distributed structure. This is not specifically limited in this application. The region of the evaporation region 12 connected to the capillary structure 400 is described in detail below.

In some embodiments of this application, a feature size of a microstructure in the microstructure layer 500 is less than a feature size of the capillary structure 400. The feature size of the capillary structure 400 may be a pore diameter of the capillary pore in the capillary structure 400.

For ease of understanding of a principle of enhancing hydrophilicity and wettability of the inner surface of the accommodating cavity with the microstructure layer 500 on the inner surface of the accommodating cavity, the following describes the principle with reference to corresponding micrographs.

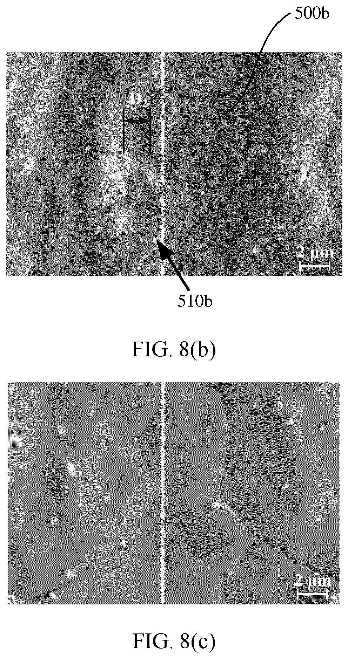

FIG. 8(a) shows a micrograph of an inner surface of an accommodating cavity in a vapor chamber 10 according to this application. FIG. 8(b) shows a micrograph of an inner surface of an accommodating cavity in another vapor chamber 10 according to this application. FIG. 8(c) shows a micrograph of an inner surface of an accommodating cavity in a vapor chamber 10b according to this application.

Compared with FIG. 8(a) and FIG. 8(c), in some implementations, the inner surface of the accommodating cavity in the vapor chamber 10b is smoother, and the microstructure layer 500a is provided on the inner surface of the accommodating cavity in the vapor chamber 10. The microstructure layer 500a presents a special shape, and includes a plurality of wave-formed roll-up structures. The roll-up structure can enhance wettability of the inner surface of the accommodating cavity 300b.

It can be learned from FIG. 8(a) that, in some implementations, micropores 510a are further provided on the plurality of wave-formed roll-up structures, and a feature size of a microstructure in the microstructure layer 500 is a pore diameter D₁ of the micropore 510a. The microstructure layer 500a improves wettability of the inner surface of the accommodating cavity through the micropores 510a, facilitates rapid spreading of liquid droplets to the condensation region 13 in the accommodating cavity, and improves a problem of liquid droplet gathering and delayed return for the vapor chamber 10.

In some implementations, a dimension range of the pore diameter D₁ of the micropore 510a on the roll-up structure ranges from 0.1 µm to 10 µm.

Further, in some implementations, a dimension range of the pore diameter D₁ of the micropore 510a on the roll-up structure ranges from 0.5 µm to 3 µm.

In addition, in some implementations, for a single roll-up structure, a dimension range of the roll-up structure in a thickness direction ranges from 0.1 µm to 10 µm, and a dimension range of the roll-up structure in a direction in which the roll-up structure is laid on the inner surface of the accommodating cavity ranges from 3 µm to 200 µm. Distribution density of the micropores 510a on the roll-up structure is 10⁴-10⁵/mm². The distribution density of the micropores 510a on the roll-up structure refers to a quantity of micropores 510a in a unit area, and a unit is quantity/mm². The laying direction is a direction that is approximately parallel to the inner surface of the accommodating cavity.

In some implementations, a distance between centers of two adjacent micropores 510a on the roll-up structure ranges from 1.5 µm to 10 µm. The distance between centers of the two micropores 510a is a distance between a center of one micropore 510a and a center of the other micropore 510a.

As shown in FIG. 8(b), in some other implementations, a microstructure in the microstructure layer 500 is a microcluster 510b, and a feature size of a micro feature in the microstructure layer 500 is a distance D₂ between two adjacent microclusters 510b. The distance D₂ between two adjacent microclusters 510b is a minimum distance between any point on one microcluster 510b and any point on the other microcluster 510b.

In some implementations, the distance between two adjacent microclusters 510b in the microstructure layer 500 ranges from 0.1 µm to 10 µm.

Further, in some implementations, the distance between two adjacent microclusters 510b in the microstructure layer 500 ranges from 0.1 µm to 5 µm.

In some embodiments of this application, a microstructure layer 500 is introduced to the capillary structure 400. To clearly describe the microstructure layer 500 on the capillary structure 400, the following first briefly describes a structural characteristic of the capillary structure 400.

The following describes several types of capillary structures 400 with reference to forms of the vapor channel 300 in the vapor chamber 10.

In some implementations, the vapor channels 300 are long straight channels that communicate with each other, and the capillary structures 400 are capillary structure walls 410 distributed in the accommodating cavity. The vapor channel 300 is formed between the capillary structure wall 410, the first plate cover 100, and the second plate cover 200.

In some other implementations, the vapor channels 300 are wavy channels that communicate with each other, and the capillary structures 400 may be wavy capillary structure walls (not shown in the figure) extending along wavy lines.

In some other implementations, the vapor channels 300 are mesh channels, and the capillary structures 400 may be a plurality of capillary structure columns (not shown in the figure) that are dispersedly distributed in the accommodating cavity.

In some implementations, the vapor channels 300 may alternatively be spiral channels that communicate with each other, and the capillary structures 400 are spiral capillary structure walls (not shown in the figure) configured to form the spiral channels.

It may be understood that a form of the capillary structure 400 and a layout of the capillary structure 400 are not specifically limited in this application, and a capillary structure 400 that can implement a vapor channel 300 in a desired form falls within the protection scope of this application. Details are not described herein. Still refer to FIG. 5(a). In some embodiments of this application, the capillary structure 400 includes a plurality of strip-shaped capillary structure walls 410, the plurality of capillary structure walls 410 are dispersedly distributed in the accommodating cavity, and gaps are formed between two end surfaces of each capillary structure wall 410 and the inner surface of the accommodating cavity. A vapor channel is formed on each of two sides of each capillary structure wall 410. Another vapor channel connected to the vapor channel is provided at an end of the capillary structure wall. A microstructure layer 500 is provided on the inner surface of the accommodating cavity used to form the vapor channel.

In some embodiments of this application, the microstructure layer 500 includes a first microstructure sublayer and a second microstructure sublayer. The first microstructure sublayer is located between two adjacent capillary structures, and is provided on a surface of the second plate cover 200. The second microstructure sublayer is located between two adjacent capillary structures 400, and is disposed on a surface of the first plate cover 100.

To prevent the vapor chamber 10 from being squashed by external atmospheric pressure, in some implementations, an end of the capillary structure 400 abuts on (or connected) to the first plate cover 100, and the other end is close to the second plate cover 200 to support the second plate cover 200. For example, the other end of the capillary structure 400 may be connected to the second plate cover 200, or the other end of the capillary structure 400 abuts on the second plate cover 200.

In some implementations of this application, the second overlapping surface 404 of the capillary structure 400 is fastened to the first plate cover 100, and the first overlapping surface 403 of the capillary structure 400 abuts on the second plate cover 200. In some other implementations of this application, the second overlapping surface 404 and the first overlapping surface 403 of the capillary structure 400 respectively abut on or fastened to the first plate cover 100 and the second plate cover 200.

In some embodiments of this application, the capillary structure 400 is a porous structure. For example, the capillary structure 400 is made of at least one of copper mesh, copper wire, copper powder, and foamed copper, and a preparation process may be sintering or etching. It may be understood that the copper mesh may be a combination of several layers of copper meshes, and a quantity of layers of the copper meshes is not specifically limited in this application. The copper powder may be a copper powder of one quantity of meshes, or may be a combination of two or more quantities of meshes. This is not specifically limited in this application.

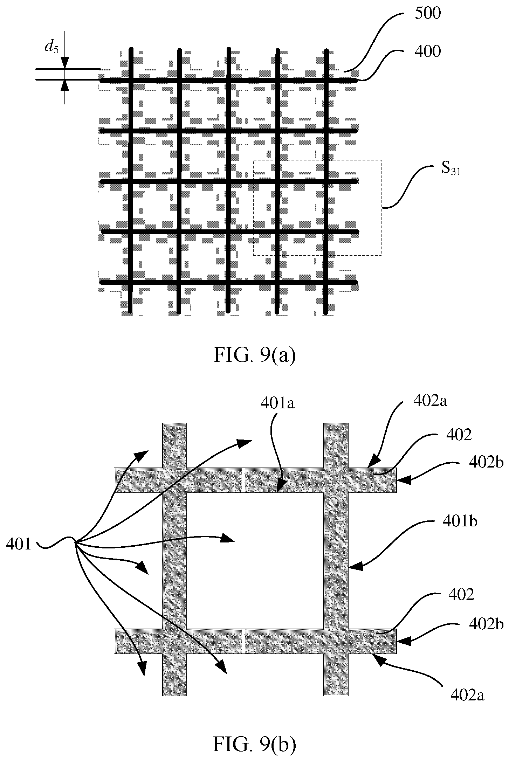

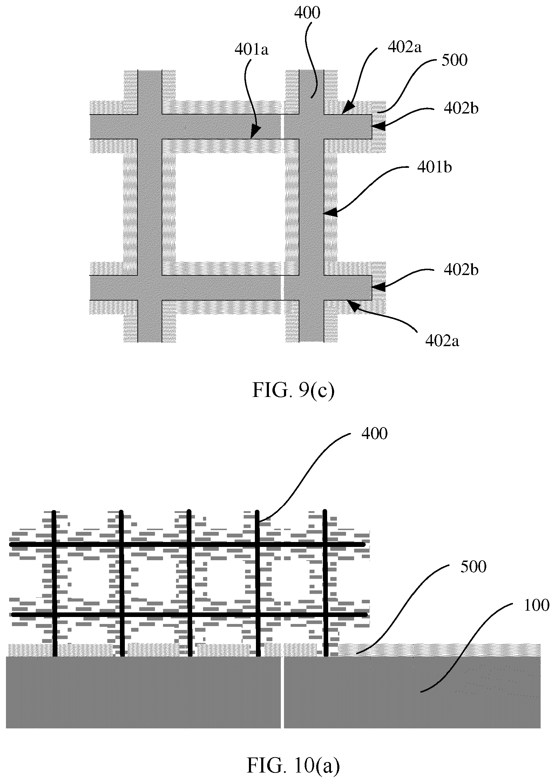

FIG. 9(a) is a partial enlarged view of the vapor chamber 10 in an S₃ region in FIG. 5(c) according to some embodiments of this application. FIG. 9(b) is a partial enlarged view of the vapor chamber 10 in an S₃₁ region in FIG. 9(a) according to some embodiments of this application. FIG. 9(c) is a partial enlarged view of the vapor chamber 10 in the S₃₁ region in FIG. 9(a) according to some other embodiments of this application.

As shown in FIG. 9(b), the capillary structure 400 has a plurality of dispersedly distributed capillary pores 401. The capillary pore has a wall surface 401a, where the capillary pore 401 is a complete pore structure formed in the capillary structure 400. In some implementations, as shown in FIG. 9(c), a microstructure layer 500 is provided on a wall surface 401a of capillary pores 401 in the capillary structure 400.

In addition, as shown in FIG. 9(b), capillary columns 402 extending outward are provided at an outer edge of the capillary structure 400, and the capillary columns 402 each has an outer end surface 402a and an outer circumferential surface 402b facing outward. The capillary pores 401 connected to the capillary columns 402 further have an outer circumferential surface 401b facing outward. To make forming less difficult, in some other implementations, as shown in FIG. 9(c), in the capillary structure 400, a microstructure layer 500 is disposed on each of the wall surface 401a of the capillary pores 401, the outer circumferential surface 401b of the capillary pores 401, the outer end surface 402a of the capillary column 402, and the outer circumferential surface 402b of the capillary column 402.

FIG. 10(a) is a partial enlarged view of the vapor chamber 10 in an S₄ region in FIG. 5(c) according to some embodiments of this application. In some embodiments of this application, as shown in FIG. 10(a), the capillary structure 400 is connected to the first plate cover 100, and the microstructure layer 500 is laid on an inner surface of the first plate cover 100 and a surface of the capillary structure 400 other than an interface on which the capillary structure 400 is connected to the first plate cover 100.

It may be understood that, for one of the capillary structures 400 with at least one end connected to the condensation region 13, in the condensation region 13 around the capillary structure 400, a region, other than an interface on which the outer end surface 402a is connected to the first plate cover 100 and an interface on which the outer end surface 402a is connected to the second plate cover 200, is a region of the condensation region 13 around the capillary structure 400 other than a region connected to the capillary structure 400. For all capillary structures 400, a region of the surrounding condensation region 13 other than a region connected to the capillary structure 400 may be obtained through the foregoing manner, and details are not described herein again. Similarly, a region of the evaporation region 12 other than a region connected to the capillary structure 400 may be obtained, and details are not described herein again.

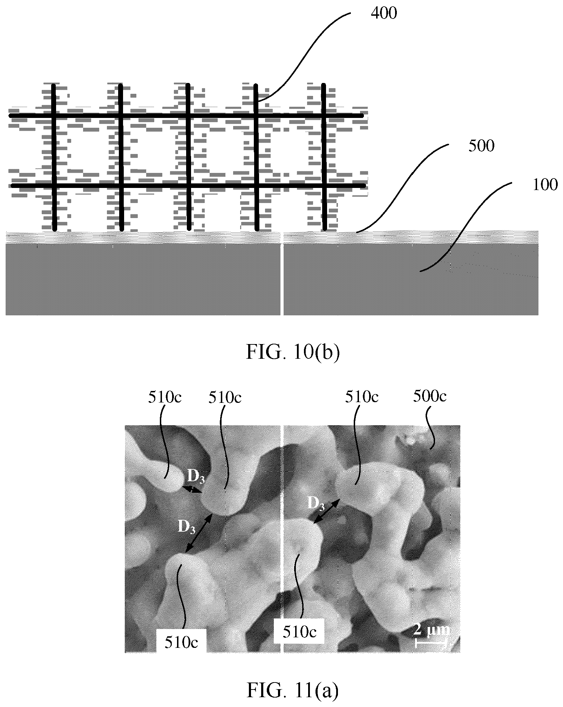

FIG. 10(b) is a partial enlarged view of the vapor chamber 10 in an S₄ region in FIG. 5(c) according to some embodiments of this application. As shown in FIG. 10(b), the capillary structure 400 is connected to the first plate cover 100, the microstructure layer 500 is laid on the inner surface of the first plate cover 100 and the capillary structure 400, and the capillary structure 400 is connected to the inner surface of the first plate cover 100 through the microstructure layer 500.

For ease of understanding of a principle of enhancing hydrophilicity, wettability, and guidance of capillary pores with the microstructure layer 500 on the capillary structure 400, the following describes the principle with reference to corresponding micrographs.

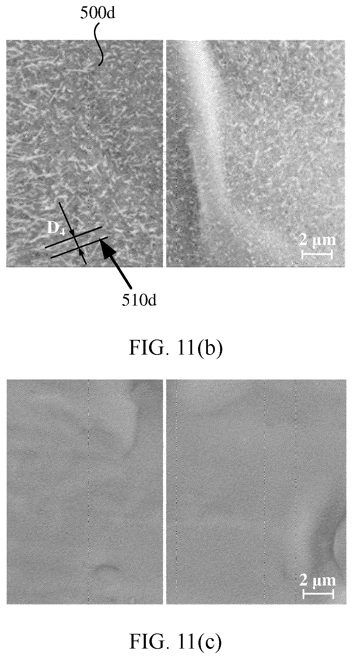

When the capillary structure 400 is made of copper mesh, FIG. 11(a) shows a micrograph of a microstructure 510c in a microstructure layer 500c on the capillary structure 400 according to some embodiments of this application. FIG. 11(b) shows a micrograph of a microstructure 510d in a microstructure layer 500d on the capillary structure 400 according to some other embodiments of this application. FIG. 11(c) shows a micrograph of a surface of the capillary structure 400 according to some other embodiments of this application.

It can be learned by comparing FIG. 11(a) and FIG. 11(c) that, in some implementations, the capillary structure 400b in the vapor chamber 10b has a relatively smooth surface except a few pores. It may be understood that the pores on copper wire in the copper mesh in FIG. 11(c) are inherent defects. The microstructure layer 500c is provided on the surface of the capillary structure 400 in the vapor chamber 10. The microstructure layer 500c presents a special shape, like coral-shaped micro protrusions 510c.

As shown in FIG. 11(a), in some implementations, space between two adjacent micro protrusions 510c on a coral-formed convex structure may be used as microspace, and the microspace can improve wettability of the capillary structure 400. A feature size of the microstructure layer 500c is a distance D₃ between two adjacent micro protrusions 510c. The micro protrusion 510c in the microstructure layer 500c strengthens capillary performance of the copper mesh, and enables liquid droplets to quickly return to the evaporation region 12. A feature size of a microstructure in the microstructure layer 500 is the distance D₃ between two adjacent micro protrusions 510c. The distance D₃ between two micro protrusions 510c is a minimum distance between any point on a surface of one micro protrusion 510c and any point on a surface of the other micro protrusion 510c.

In some implementations, a dimension range of the distance D₃ between two adjacent micro protrusions 510c ranges from 0.1 µm to 10 µm.

Further, in some implementations, the dimension range of the distance D₃ between two adjacent micro protrusions 510c ranges from 0.2 µm to 5 µm.

In some implementations, a dimension range of the micro protrusion 510c ranges from 0.1 µm to 10 µm.

Further, in some implementations, the dimension range of the micro protrusion 510c ranges from 0.5 µm to 5 µm.

As shown in FIG. 11(b), in some other implementations, a microstructure in the microstructure layer 500 is microlines 510d. An end of the microline 510d is connected to the wall surface of capillary pores in the capillary structure 400, and the other end of the microline 510d extends toward the inside of the capillary pore. The feature size of the microstructure in the microstructure layer 500 is a distance D₄ between two adjacent microlines 510d. The distance D₄ between two microlines 510d is a minimum distance between an end of one microline 510d connected to the wall surface of capillary pores and an end of the other microline 510d connected to the wall surface of capillary pores.

In some implementations, a distance between two adjacent microlines 510d ranges from 0.1 µm to 10 µm.

Further, in some implementations, the distance between two adjacent microlines 510d ranges from 0.2 µm to 3 µm.

In some implementations, a diameter range of the microline 510d ranges from 0.02 µm to 0.2 µm, and a line length range of the microline 510d ranges from 0.5 µm to 5 µm. The line length of the microline 510d is a distance from an end of the microline 510d to the other end of the microline 510d.

According to the vapor chamber 10 in this application, the microstructure layer 500 is introduced to the capillary structure 400, so that a capillary capability of the capillary structure 400 is enhanced, a liquid-phase working medium can quickly return from a condensation region to an evaporation region, and temperature uniformity performance of the vapor chamber 10 is improved. Therefore, temperature uniformity performance and reliability of the vapor chamber 10 can be further improved.

To prevent the working medium from leaking from the sealed accommodating cavity to an external environment, a sealing measure further needs to be taken to improve sealing performance of the accommodating cavity formed by the first plate cover and the second plate cover.

In some implementations, a sealing member (not shown in the figure) is provided at a connection interface between the first plate cover 100 and the second plate cover 200, and/or a position at which the first plate cover 100 and the second plate cover 200 are connected is welded by using solder, and a sealing coating (not shown in the figure) is coated at the welding position. In the vapor chamber 10, sealing performance of the accommodating space is improved with the sealing member, the solder, and the sealing coating. This reduces a probability that the working medium leaks to the external environment through a gap between the first plate cover 100 and the second plate cover 200, and improves reliability of a process of using the vapor chamber 10.

To improve a temperature uniformity effect of the vapor chamber 10, in some implementations, the heat conductive region 11 is coated with a thermal conductive gel, to reduce thermal contact resistance of an interface.

In some embodiments of this application, the first plate cover 100, the second plate cover 200, and the capillary structure 400 are made of at least one of copper, copper alloy, titanium, and titanium alloy, and a forming manner of the microstructure layer 500 includes at least one of high-temperature oxidation, high-temperature oxidation and high-temperature reduction, and electrodeposition. When the forming manner of the microstructure layer 500 is high-temperature oxidation and high-temperature reduction, the microstructure layer 500 has a stable structure and a longer service life. When the forming manner of the microstructure layer 500 is electrodeposition, the microstructure layer 500 may present as a dendriform convex structure or a geometrically arranged microcolumn.

In some embodiments of this application, the vapor chamber 10 further includes a working medium located in the accommodating cavity. The working medium may be any one of water, methanol, acetone, and liquid ammonia. The water may be deionized water.

After the vapor chamber 10 provided in this application is described, the following describes beneficial effects of the vapor chamber 10 with reference to an experimental result.

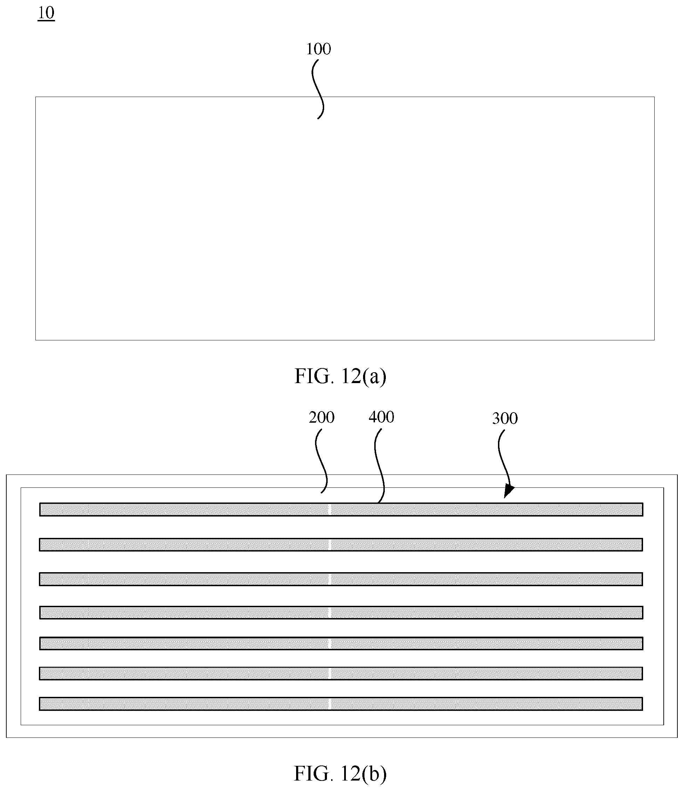

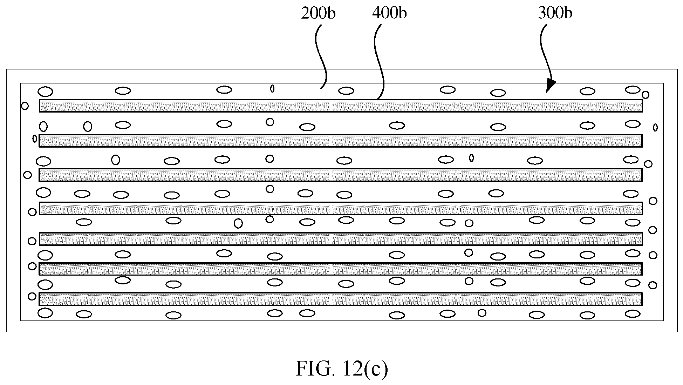

FIG. 12(a) is a bottom view of a vapor chamber 10 according to some embodiments of this application. FIG. 12(b) is a bottom view of a vapor chamber 10 according to some embodiments of this application, where a first plate cover 100 is removed. FIG. 12(c) is a bottom view of a vapor chamber 10b according to some embodiments of this application, where a first plate cover 100b is removed.

It can be learned by comparing FIG. 12(b) and FIG. 12(c) that, under a same experimental condition, for example, after a same quantity of tests, in the vapor chamber 10b before improvement, liquid droplets gather on an inner surface of a second plate cover 200b. After use of the solution and process improvement, gathering of liquid droplets does not occur on an inner surface of a second plate cover 200 in the vapor chamber 10.

Table 1 shows thermal performance test data of the vapor chamber 10 before and after thermal shock in this application.

**Table 1 Thermal performance test data of the vapor chamber 10**

| Test number | Before | | After | | Determining result |
|---|---|---|---|---|---|
| | Δt₂/°C | Δt₃/°C | Δt₂'/°C | Δt₃'/°C | √ |
| 1 | 2.4 | 3.1 | 3 | 3 | √ |
| 2 | 2 | 2.9 | 2.1 | 3 | √ |
| 3 | 2.1 | 3.5 | 2.6 | 3.4 | √ |
| 4 | 2.1 | 2.8 | 2.1 | 2.9 | √ |
| 5 | 1.8 | 2.7 | 1.9 | 3.1 | √ |
| 6 | 1.8 | 2.6 | 2.9 | 3.4 | √ |
| 7 | 2.1 | 2.9 | 2.3 | 3 | √ |
| 8 | 1.9 | 2.6 | 2 | 2.6 | √ |
| 9 | 2 | 2.6 | 2.4 | 2.9 | √ |
| 10 | 2.2 | 2.9 | 2.3 | 2.7 | √ |
| 11 | 2.5 | 3.5 | 2.6 | 3.2 | √ |
| 12 | 2.5 | 2.9 | 2.1 | 2.6 | √ |
| 13 | 2 | 3.6 | 2.1 | 2.6 | √ |
| 14 | 2.2 | 3.4 | 2.3 | 2.5 | √ |
| 15 | 2.1 | 3.2 | 2.1 | 2.6 | √ |
| 16 | 1.9 | 3.1 | 1.9 | 2.5 | √ |
| 17 | 2.2 | 3.5 | 1.9 | 2.5 | √ |
| 18 | 2.1 | 3 | 1.9 | 2.5 | √ |
| 19 | 1.9 | 3 | 1.8 | 2.8 | √ |
| 20 | 2.1 | 3.7 | 2 | 2.7 | √ |
| 21 | 3.2 | 3.6 | 2.8 | 3.6 | √ |
| 22 | 2.4 | 3.2 | 2.4 | 2.7 | √ |
| 23 | 2.5 | 2.9 | 2.2 | 2.8 | √ |
| 24 | 2.1 | 2.6 | 2.1 | 2.6 | √ |
| 25 | 2.5 | 3.7 | 2.4 | 3 | √ |
| 26 | 2.2 | 3.1 | 2.2 | 2.8 | √ |

The thermal shock refers to processing performed on the vapor chamber 10 according to a cold and hot cycling condition. Thermal performance test data of the vapor chamber 10 after the thermal shock can reflect reliability of the vapor chamber 10. The cold and hot cycling condition is as follows: The vapor chamber 10 is kept in a low-temperature environment for first preset duration; then the low temperature is raised to a high temperature for the vapor chamber 10 within second preset duration; and the vapor chamber 10 is kept in the high-temperature environment for third preset duration. For example, the vapor chamber 10 is kept in a -40°C environment for 30 min, then a temperature is increased from -40°C to 85°C for the vapor chamber 10 within 1 min, and the vapor chamber 10 is kept at 85°C for 30 min. The foregoing is a cycle, and there are 24 cycles in total.

Table 2 shows thermal performance test data of the vapor chamber 10b before thermal shock in this application.

**Table 2 Thermal performance test data of the vapor chamber 10b**

| Sample | Test number | Δt₁/°C | Δt₂/°C | Δt₃/°C | Determining result |
|---|---|---|---|---|---|
| Sample I | 1 | 4.06 | 4.12 | 3.87 | √ |
| | 2 | 4.15 | 5.09 | 4.85 | × |
| | 3 | 3.36 | 6.74 | 6.39 | × |
| Sample II | 1 | 3.86 | 3.85 | 4.2 | √ |
| | 2 | 4.52 | 4.55 | 4.14 | √ |
| | 3 | 3.18 | 4.98 | 5.12 | × |
| Sample III | 1 | 4.42 | 4.5 | 4.36 | √ |
| | 2 | 3.82 | 4.98 | 4.67 | √ |
| | 3 | 3.46 | 6.48 | 5.17 | × |

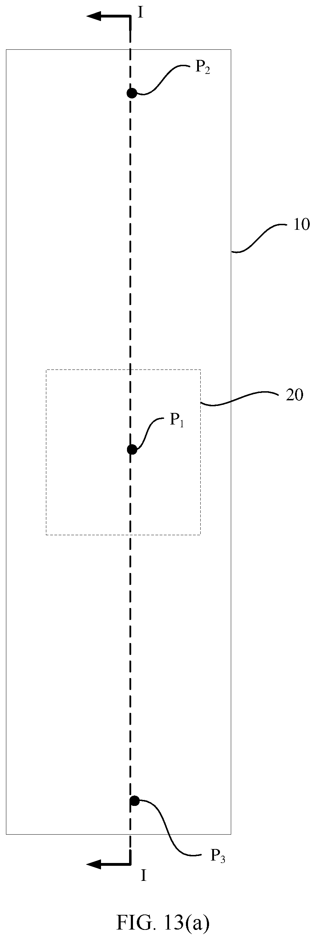

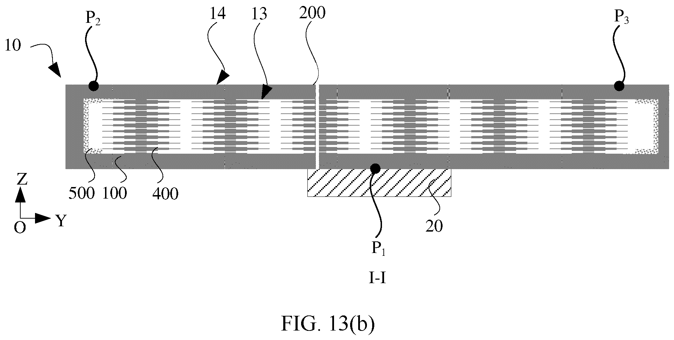

It is not difficult to find in Table 2 that thermal performance of the vapor chamber 10b deteriorates in previous several tests (for example, the second or the third test). Therefore, no thermal performance test after thermal shock is performed on the vapor chamber 10b. It may be understood that, in Table 1 and Table 2, Δt₁ = T_{C} - T₁, Δt₂ = T₁ - T₂, and Δt₃ = T₁ - T₃. T_{C} is a temperature of a chip 20, T₁ is a temperature of the vapor chamber 10 at P₁, T₂ is a temperature of the vapor chamber 10 at P₂, and T₃ is a temperature of the vapor chamber 10 at P₃, as shown in FIG. 13(a) and FIG. 13(b). FIG. 13(a) is a top view of the vapor chamber 10 according to some embodiments of this application, where a position of a heat source (for example, the chip 20) is further shown. FIG. 13(b) is a sectional view of the vapor chamber 10 along an I-I cross section in FIG. 13(a). The meaning represented by Δt₂' is roughly the same as that represented by Δt₂. The difference lies in that Δt₂ represents a state before the thermal shock, and Δt₂' represents a state after the thermal shock. Similarly, the meaning represented by Δt₃' is roughly the same as that represented by Δt₃. The difference lies in that Δt₃ represents a state before the thermal shock, and Δt₃' represents a state after the thermal shock.

It can be learned by comparing Table 1 and Table 2 that, in the vapor chamber 10 in this application, a temperature difference of the vapor chamber 10 does not increase significantly and temperature uniformity performance does not deteriorate significantly before and after the thermal shock. Therefore, thermal performance is stable, and reliability is high. In addition, it can be learned from Table 2 that, a temperature difference of the vapor chamber 10b prepared according to a conventional process increases repeatedly. In other words, thermal performance of the vapor chamber 10b meets a requirement in the first test, but after several tests, thermal performance of the vapor chamber 10b cannot meet the requirement, where a criterion of meeting the requirement may be that Δt is less than 5°C. It can be learned from FIG. 12(a) to FIG. 12(c) that, after the sample of the vapor chamber 10b is cut off, dot-shaped and strip-shaped water droplets are found on an inner surface of a vapor channel 300b in the vapor chamber 10b. Because it is difficult for condensate droplets to quickly return to a capillary structure 400b, an evaporation region 12b in the vapor chamber 10b is dried out, and a temperature difference increases.

After the improvement solution of the vapor chamber 10b is described, it is not difficult to find that the improvement solution of the vapor chamber 10b may also be applied to the vapor chamber 10a. The following briefly describes an improvement solution of the vapor chamber 10a with reference to a difference between structures of the vapor chamber 10a and the vapor chamber 10b and a problem that may occur in use of the vapor chamber 10a.

It may be understood that, for the vapor chamber 10a mentioned above, to enable a liquid-phase working medium to return, a thickness of a support column 600a further needs to be limited. In a thin vapor chamber 10a, generally, a height of the vapor channel 300a is also relatively low. After accumulating to a specific extent, the liquid-phase working medium is in contact with the capillary structure 400a under an action of gravity of the liquid-phase working medium and is absorbed by the capillary structure 400a, and then returns to the evaporation region 12a mentioned above. However, in a thick vapor chamber 10a, generally, a height of the vapor channel 300a is relatively high. The liquid-phase working medium needs to gather into a large liquid droplet to drop or be in contact with the capillary structure 400a, which causes delayed return, and affects temperature uniformity performance of the vapor chamber 10a.

To assist in return and improve temperature uniformity of the vapor chamber 10a, the vapor chamber 10a further includes a powder ring (not shown in the figure) provided on an outer edge of the support column 600a, to help liquid droplets flow through the powder ring to the capillary structure 400a and then return to the evaporation region 12a. A structure characteristic of the powder ring is similar to the capillary structure, and may be used as a capillary structure. Details are not described herein. The addition of the powder ring reduces space of the vapor channel 300a, but increases preparation costs of the vapor chamber 10a.

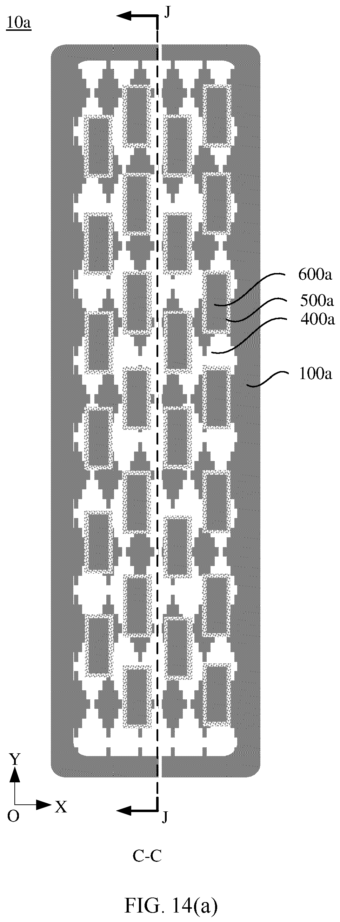

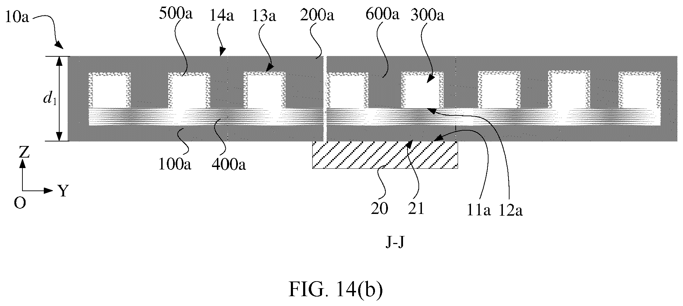

Based on this, FIG. 14(a) is a sectional view of the vapor chamber 10a along a C-C cross section in FIG. 2(a) according to some other embodiments of this application. FIG. 14(b) is a sectional view of the vapor chamber 10a along a J-J cross section in FIG. 14(a) according to some other embodiments of this application.

As shown in FIG. 14(a) and FIG. 14(b), in some embodiments of this application, a microstructure layer 500 is disposed on an inner surface of an accommodating cavity in the vapor chamber 10a. An improvement principle and an improvement manner of the microstructure layer 500 are similar to those of the vapor chamber 10b. Details are not described herein again.

In some implementations, a microstructure layer 500a is also introduced to the capillary structure 400a. The microstructure layer 500a is the same as the microstructure layer 500 in the foregoing vapor chamber 10, and details are not described herein again.

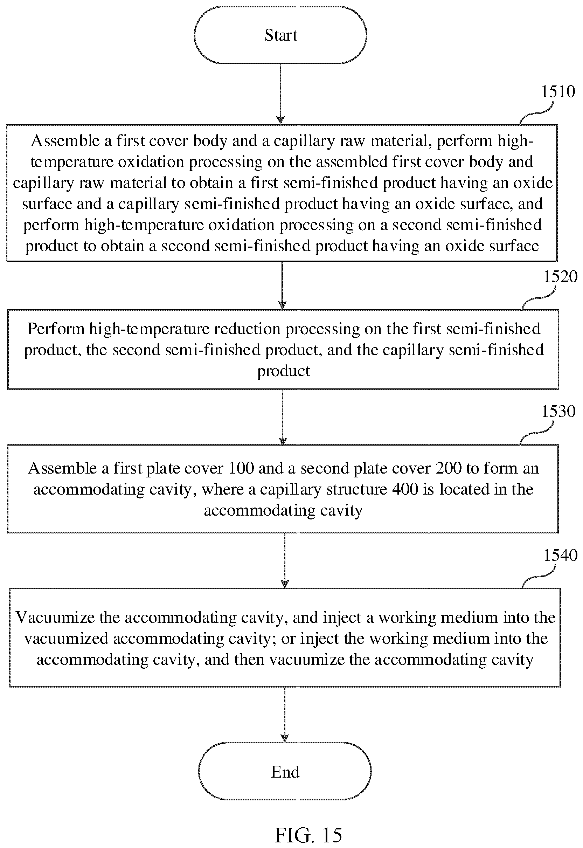

After a specific structure of the vapor chamber 10 is described, the following proceeds to description of a method for forming the vapor chamber 10. FIG. 15 is a flowchart of forming the vapor chamber 10 according to some embodiments of this application. As shown in FIG. 15, the method for forming the vapor chamber 10 specifically includes the following steps:

Step 1510: Assemble a first cover body and a capillary raw material, perform high-temperature oxidation processing on the assembled first cover body and capillary raw material to obtain a first semi-finished product having an oxide surface and a capillary semi-finished product having an oxide surface, and perform high-temperature oxidation processing on a second semi-finished product to obtain a second semi-finished product having an oxide surface.

The first cover body is an initial raw material of a first plate cover. The capillary raw material is an initial raw material of a capillary structure. For example, the capillary raw material is copper mesh, copper wire, copper powder, or the like. The assembly of the first cover body and the capillary raw material may be press-fitting the capillary raw material on the first cover body, or may be another assembly manner. This is not specifically limited in this application. For example, the assembled first cover body and the capillary raw material are placed in a gas atmosphere of oxygen, oxygen-nitrogen mixed gas, or air, and are heated for 10 min to 5 h at a 300-600°C temperature. For example, the heating temperature may be any one of 300°C, 350°C, 400°C, 450°C, 500°C, 550°C, and 600°C. A heat preservation time may be any one of 10 min, 20 min, 30 min, 40 min, 50 min, 1h, 2h, 3h, 4h, and 5h.

The second cover body is an initial raw material of a second plate cover. It may be understood that ranges of process parameters for high-temperature oxidation processing on the second cover body, the first cover body, and the capillary raw material are the same. However, process parameters of high-temperature oxidation processing on the first cover body and the capillary raw material may be the same as or different from process parameters of high-temperature oxidation processing on the second cover body. This is not specifically limited in this application.

In some implementations, high-temperature oxidation processing on the first cover body and the capillary raw material and high-temperature oxidation processing on the second cover body may be performed simultaneously, or may be performed separately. When the two processes of high-temperature oxidation are separately processed, a sequence is not specifically limited in this application.

Step 1520: Perform high-temperature reduction processing on the first semi-finished product, the second semi-finished product, and the capillary semi-finished product.

It may be understood that, through the high-temperature reduction processing, an oxide skin is reduced, and the first semi-finished product and the capillary semi-finished product are sintered, to fasten a first plate cover 100 to a capillary structure 400.

For example, the first semi-finished product and the second semi-finished product that have an oxide surface are placed in a nitrogen-hydrogen mixed gas atmosphere, and are heated for 10 min to 10 h at a 500-800°C temperature. For example, the heating temperature may be any one of 500°C, 550°C, 600°C, 650°C, 700°C, 750°C, and 800°C. The heat preservation time may be any one of 10 min, 20 min, 30 min, 40 min, 50 min, 1h, 2h, 3h, 4h, 5h, 6h, 7h, and 8h.

Step 1530: Assemble the first plate cover 100 and the second plate cover 200 to form an accommodating cavity, where the capillary structure 400 is located in the accommodating cavity. The assembly process may be welding the first plate cover 100 and the second plate cover 200 as a whole by using a solder, or adhering the first plate cover 100 and the second plate cover 200 as a whole by using an adhesive material.

Step 1540: Vacuumize the accommodating cavity between the first plate cover 100 and the second plate cover 200, and inject a working medium into the vacuumized accommodating cavity. Alternatively, the working medium is injected into the accommodating cavity between the first plate cover 100 and the second plate cover 200, and then the accommodating cavity is vacuumized.

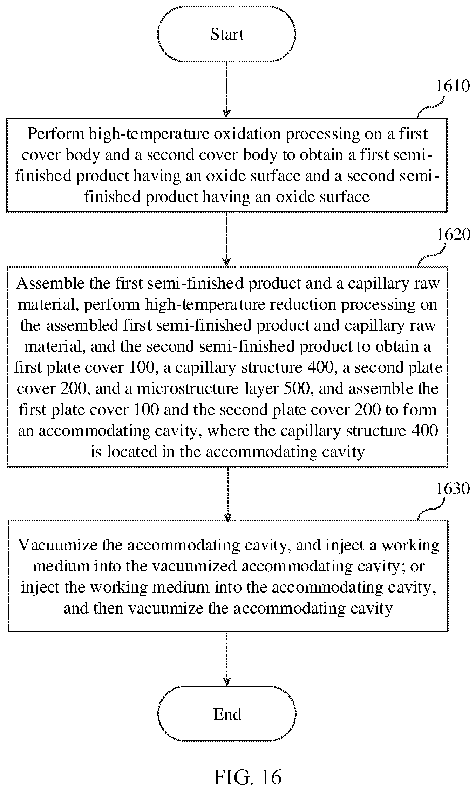

This application further provides another method for forming the vapor chamber 10. FIG. 16 is a flowchart of forming the vapor chamber 10 according to some other embodiments of this application. As shown in FIG. 16, the another method for forming the vapor chamber 10 specifically includes the following steps:

Step 1610: Perform high-temperature oxidation processing on a first cover body and a second cover body to obtain a first semi-finished product having an oxide surface and a second semi-finished product having an oxide surface.

Step 1620: Assemble the first semi-finished product and a capillary raw material, perform high-temperature reduction processing on the assembled first semi-finished product and capillary raw material, and the second semi-finished product to obtain a first plate cover 100, a capillary structure 400, a second plate cover 200, and a microstructure layer 500, and assemble the first plate cover 100 and the second plate cover 200 to form an accommodating cavity, where the capillary structure 400 is located in the accommodating cavity.

To be specific, the assembly process may be welding the first plate cover 100 and the second plate cover 200 as a whole by using a solder, or adhering the first plate cover 100 and the second plate cover 200 as a whole by using an adhesive material. Through the high-temperature reduction processing on the first semi-finished product and the capillary raw material, an oxide on a surface of the first semi-finished product is reduced, the first semi-finished product and the capillary raw material are sintered, which simplifies operation steps.

Step 1630: Vacuumize the accommodating cavity between the first plate cover 100 and the second plate cover 200, and inject a working medium into the vacuumized accommodating cavity. Alternatively, the working medium is injected into the accommodating cavity between the first plate cover 100 and the second plate cover 200, and then the accommodating cavity is vacuumized.

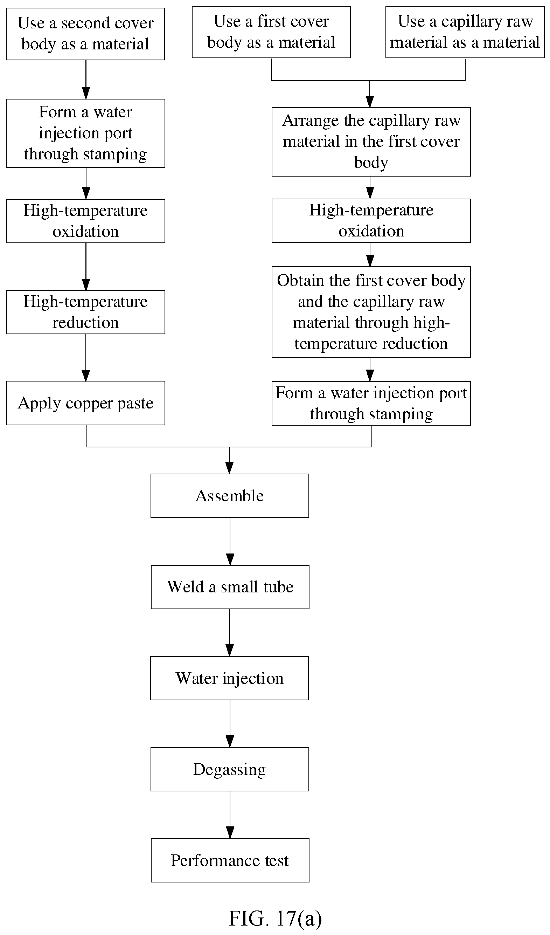

After the foregoing forming solution of the vapor chamber 10 is described, a process of forming the vapor chamber 10 is further described in detail, as shown in FIG. 17(a).

First, the second cover body is used as a material, a water injection port is formed on the second cover body through stamping, and heat processing is performed on the second cover body, for example, a high-temperature oxidation reaction is performed. The water injection port formed on the second cover body through stamping is configured to ensure that water can smoothly enter the vapor chamber 10 in a water injection process. The second cover body may be a copper plate, may be a copper alloy plate, or may be a titanium alloy plate. A material of the second cover body is not limited herein.

Then, the first cover body is used as a material, a capillary raw material is formed in the first cover body, a water injection port is formed on the first cover body through stamping, and heat processing is performed on the first cover body and the capillary raw material, for example, a high-temperature oxidation reaction is performed. The capillary raw material formed in the first cover body is specifically configured to arrange a raw material used for forming the capillary structure 400 in the first cover body, to properly arrange the capillary structure 400 and a vapor channel.

Then, the capillary raw material and the first cover body are sintered to ensure that the capillary structure 400 is connected to the first plate cover 100 at a specific position, thereby ensuring that no shift occurs in a long-term use process. In addition, high-temperature reduction of the capillary structure 400 and the first plate cover 100 can be implemented.

Next, a solder (for example, solder paste) is spot-coated on edges of the first plate cover 100 and/or the second plate cover 200. In some implementations, the solder is copper paste.

Afterward, the first plate cover 100 and the second plate cover 200 that are coated with the copper paste are assembled by using a positioning jig.

Then, the first plate cover 100 and the second plate cover 200 are sealed through brazing.

After that, small pipes are welded at the water injection ports of the first plate cover 100 and the second plate cover 200, so as to facilitate subsequent injection of the working medium and degassing.

The working medium is then injected into the accommodating cavity of the vapor chamber 10.

Finally, the accommodating cavity of the vapor chamber 10 is degassed to make the vapor chamber 10 have a specific degree of vacuum inside, so that water is more easily to evaporate, thereby implementing phase-change heat exchange of the vapor chamber 10 at a relatively low operating temperature.

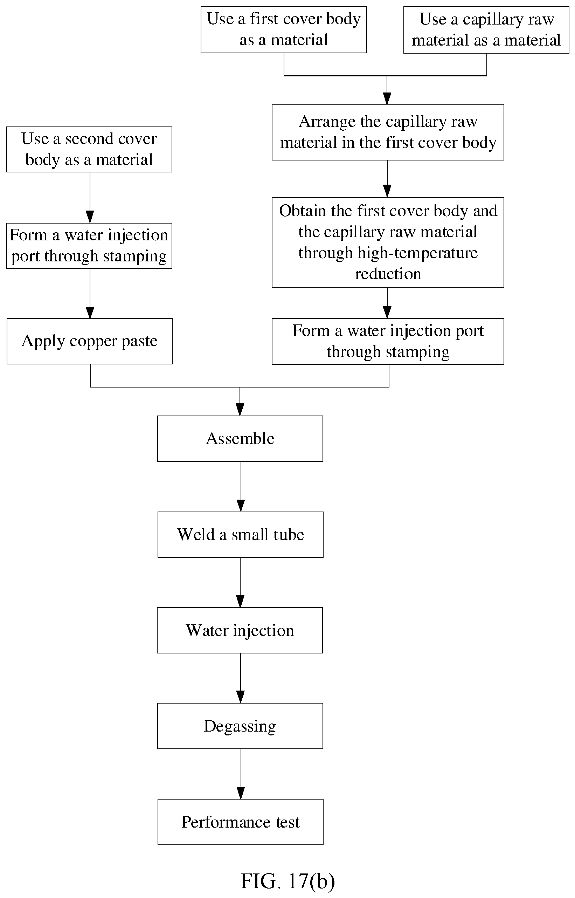

It may be understood that, a forming process of the vapor chamber 10b is basically similar to that of the vapor chamber 10 as shown in FIG. 17(b), except that high-temperature oxidation does not need to be performed on the first cover body, the second cover body, and the capillary raw material. Details are not described herein again.

This application further provides a circuit module. The circuit module includes the at least one vapor chamber 10, a circuit board 30, and an electronic component mounted on the circuit board 30, where the electronic component is a heat source. A first plate cover 100 abuts on a surface of the electronic component through a heat conductive surface, where the heat conductive surface is an outer surface that is on a first plate cover 100 and that is provided opposite to an evaporation region 12.

This application further provides an electronic device, including at least one of the foregoing circuit modules.

The foregoing describes implementations of this application by using specific embodiments. A person skilled in the art may easily learn of other advantages and effects of this application based on content disclosed in this specification. Although this application is described with reference to some embodiments, it does not mean that a characteristic of this application is limited only to the implementation. On the contrary, a purpose of describing this application with reference to an implementation is to cover another option or modification that may be derived based on claims of this application. This application may be alternatively implemented without using these details. In addition, to avoid confusion or blurring a focus of this application, some specific details are omitted from the description. It should be noted that embodiments in this application and the features in embodiments may be mutually combined in the case of no conflict.

In the description of this application, it should be noted that an orientation or a location relationship indicated by terms "central", "upper", "lower", "left", "right", "vertical", "horizontal", "outer", "inner", "circumferential", "radial", "axial" or the like is an orientation or a location relationship based on the accompanying drawings, and is merely used to facilitate and simplify description of this application, instead of indicating or implying that a mentioned apparatus or component needs to have a specific orientation or be constructed and operated in a specific orientation, and therefore the terms cannot be construed as a limitation on this application.

In the description of this application, it should be noted that, unless otherwise specified and limited, terms "setting", "mounting", "connecting", and "abutting" should be understood in a broad sense, for example, may be a fixed connection, a detachable connection, or an integral connection; may be a mechanical connection or an electrical connection; or may be a direct connection, an indirect connection via an intermediate medium, or an internal connection between two components. A person of ordinary skill in the art should understand specific meanings of the foregoing terms in this application based on specific situations.

It is clear that a person skilled in the art can make various modifications and variations to this application without departing from the scope of this application. This application is intended to cover these modifications and variations of this application provided that they fall within the scope of protection defined by the claims of this application.

## Claims

1. A vapor chamber (10), configured to dissipate heat for a heat source, comprising:
a first plate cover (100);
a second plate cover (200), wherein the first plate cover (100) and the second plate cover (200) overlap along an overlapping direction to jointly form a sealed accommodating cavity, and a heat conductive surface configured to abut on the heat source is provided on a side that is of the first plate cover (100) and that faces away from the accommodating cavity, wherein the overlapping direction is a direction in which the vapor chamber (10) and the heat source are stacked; and
a capillary structure (400), wherein the capillary structure (400) is located in the accommodating cavity, the capillary structure (400) has a pair of a first overlapping surface (403) and a second overlapping surface (404) that are opposite to each other and perpendicular to the overlapping direction, the first overlapping surface (403) of the capillary structure (400) is connected to the second plate cover (200), and the second overlapping surface (404) of the capillary structure (400) is connected to the first plate cover (100) to support the first plate cover (100) and the second plate cover (200) in the overlapping direction, the vapor chamber being **characterized in that**
a microstructure layer (500) is provided on an inner surface of the accommodating cavity and a wall surface of capillary pores in the capillary structure (400), and the microstructure layer (500) is configured to guide a liquid-phase working medium in the vapor chamber (10).

2. The vapor chamber (10) according to claim 1, wherein
the capillary structure (400) comprises a plurality of strip-shaped capillary structure walls (410), the plurality of capillary structure walls (410) are dispersedly distributed in the accommodating cavity, and a gap is formed between the inner surface of the accommodating cavity and a surface of each capillary structure wall (410) other than the first overlapping surface (403) and the second overlapping surface (404).

3. The vapor chamber (10) according to claim 2, wherein a plurality of first vapor channels are formed on two sides of the capillary structure walls (410), second vapor channels communicating with the plurality of first vapor channels are provided at ends of the capillary structure walls (410), and the microstructure layer (500) is provided on the inner surface that is of the accommodating cavity and that is opposite to the first vapor channel and the second vapor channel.

4. The vapor chamber (10) according to any one of claims 1 to 3, wherein a dimension range of the capillary structure (400) in the overlapping direction ranges from 0.05 mm to 0.5 mm, and a thickness range of the microstructure layer (500) ranges from 0.1 µm to 20 µm.

5. The vapor chamber (10) according to any one of claims 1 to 3, wherein
a feature size of a microstructure in the microstructure layer (500) is less than a feature size of the capillary structure (400), wherein the feature size of the capillary structure (400) is a pore diameter of the capillary pore in the capillary structure (400), and the feature size of the microstructure is a size of a technical feature related to wettability of the microstructure layer (500).

6. The vapor chamber (10) according to claim 5, wherein the microstructure layer (500) comprises a plurality of wave-formed roll-up structures laid on the inner surface of the accommodating cavity, and a plurality of micropores are formed on a surface of each roll-up structure.

7. The vapor chamber (10) according to claim 6, wherein the feature size of the microstructure is a pore diameter of the micropore, and a pore diameter range of the micropore ranges from 0.1 µm to 10 µm.

8. The vapor chamber (10) according to claim 5, wherein the microstructure layer (500) comprises a plurality of microclusters laid on the inner surface of the accommodating cavity.

9. The vapor chamber (10) according to claim 8, wherein a feature size of the microstructure is a distance between two adjacent microclusters, and the distance between two adjacent microclusters ranges from 0.1 µm to 10 µm.

10. The vapor chamber (10) according to claim 5, wherein the microstructure layer (500) comprises a plurality of microlines, an end of the microline is connected to the wall surface of the capillary pores in the capillary structure (400), and the other end of the microline extends toward the inside of the capillary pore.

11. The vapor chamber (10) according to claim 10, wherein the feature size of the microstructure is a distance between two adjacent microlines, and the distance between two adjacent microlines ranges from 0.1 µm to 10 µm, wherein the distance between two adjacent microlines is a distance from an end, of one of the microlines, connected to the wall surface of the capillary pores to an end, of the other microline, connected to the wall surface of the capillary pores.

12. The vapor chamber (10) according to claim 5, wherein the microstructure layer (500) comprises coral-shaped micro protrusions formed on the wall surface of the capillary pores in the capillary structure (400).

13. The vapor chamber (10) according to claim 12, wherein the feature size of the microstructure is a distance between two adjacent micro protrusions, and the distance between two adjacent micro protrusions ranges from 0.1 µm to 10 µm.

14. The vapor chamber (10) according to claim 1, wherein the accommodating cavity comprises a condensation region (13), a first region of the condensation region (13) is provided with the microstructure layer (500), and the first region is a region of the condensation region (13) other than a region connected to the capillary structure (400).

15. The vapor chamber (10) according to claim 14, wherein the accommodating cavity further comprises an evaporation region (12), a second region of the evaporation region (12) is provided with the microstructure layer (500), and the second region is a region of the evaporation region (12) other than a region connected to the capillary structure (400).

16. The vapor chamber (10) according to claim 15, wherein
the microstructure layer (500) guides the liquid-phase working medium to the capillary structure (400), and the capillary structure (400) guides the liquid-phase working medium to the evaporation region (12).

17. A circuit module, comprising the vapor chamber (10) according to any one of claims 1 to 16, a circuit board (30), and an electronic component mounted on the circuit board (30), wherein
the electronic component is the heat source; and
the first plate cover (100) abuts on a surface of the electronic component through the heat conductive surface.

18. An electronic device, comprising at least one circuit module according to claim 17.

## Patentansprüche

1. Dampfkammer (10), die konfiguriert ist, um Wärme für eine Wärmequelle abzuleiten, die umfasst:
eine erste Plattenabdeckung (100);
eine zweite Plattenabdeckung (200), wobei die erste Plattenabdeckung (100) und die zweite Plattenabdeckung (200) sich entlang einer Überlappungsrichtung überlappen, um gemeinsam einen abgedichteten Aufnahmehohlraum auszubilden, und eine wärmeleitfähige Oberfläche, die konfiguriert ist, um an der Wärmequelle anzuliegen, auf einer Seite der ersten Plattenabdeckung (100) bereitgestellt ist, die von dem Aufnahmehohlraum abgewandt ist, wobei die Überlappungsrichtung eine Richtung ist, in der die Dampfkammer (10) und die Wärmequelle gestapelt sind; und
eine Kapillarstruktur (400), wobei sich die Kapillarstruktur (400) in dem Aufnahmehohlraum befindet, die Kapillarstruktur (400) ein Paar aus einer ersten Überlappungsoberfläche (403) und einer zweiten Überlappungsoberfläche (404) aufweist, die einander gegenüberliegen und senkrecht zu der Überlappungsrichtung stehen, die erste Überlappungsoberfläche (403) der Kapillarstruktur (400) mit der zweiten Plattenabdeckung (200) verbunden ist und die zweite Überlappungsoberfläche (404) der Kapillarstruktur (400) mit der ersten Plattenabdeckung (100) verbunden ist, um die erste Plattenabdeckung (100) und die zweite Plattenabdeckung (200) in der Überlappungsrichtung zu stützen, wobei die Dampfkammer **dadurch gekennzeichnet, dass**
eine Mikrostrukturschicht (500) auf einer Innenoberfläche des Aufnahmehohlraums und einer Wandoberfläche von Kapillarporen in der Kapillarstruktur (400) bereitgestellt ist, und die Mikrostrukturschicht (500) konfiguriert ist, um ein flüssigphasiges Arbeitsmedium in der Dampfkammer (10) zu führen.

2. Dampfkammer (10) nach Anspruch 1, wobei
die Kapillarstruktur (400) eine Vielzahl von streifenförmigen Kapillarstrukturwänden (410) umfasst, die Vielzahl von Kapillarstrukturwänden (410) verstreut in dem Aufnahmehohlraum verteilt ist und zwischen der Innenoberfläche des Aufnahmehohlraums und einer Oberfläche jeder Kapillarstrukturwand (410) mit Ausnahme der ersten Überlappungsoberfläche (403) und der zweiten Überlappungsoberfläche (404) ein Spalt ausgebildet ist.

3. Dampfkammer (10) nach Anspruch 2, wobei eine Vielzahl von ersten Dampfkanälen auf zwei Seiten der Kapillarstrukturwände (410) ausgebildet sind, zweite Dampfkanäle, die mit der Vielzahl von ersten Dampfkanälen in Kommunikation stehen, an Enden der Kapillarstrukturwände (410) bereitgestellt sind und die Mikrostrukturschicht (500) auf der Innenoberfläche, die zu dem Aufnahmehohlraum gehört, bereitgestellt ist, die dem ersten Dampfkanal und dem zweiten Dampfkanal gegenüberliegt.

4. Dampfkammer (10) nach einem der Ansprüche 1 bis 3, wobei ein Abmessungsbereich der Kapillarstruktur (400) in der Überlappungsrichtung in einem Bereich von 0,05 mm bis 0,5 mm liegt und ein Dickenbereich der Mikrostrukturschicht (500) in dem Bereich von 0,1 µm bis 20 µm liegt.

5. Dampfkammer (10) nach einem der Ansprüche 1 bis 3, wobei eine Merkmalsgröße einer Mikrostruktur in der Mikrostrukturschicht (500) kleiner als eine Merkmalsgröße der Kapillarstruktur (400) ist, wobei die Merkmalsgröße der Kapillarstruktur (400) ein Porendurchmesser der Kapillarpore in der Kapillarstruktur (400) ist und die Merkmalsgröße der Mikrostruktur eine Größe eines technischen Merkmals ist, das mit einer Benetzbarkeit der Mikrostrukturschicht (500) zusammenhängt.

6. Dampfkammer (10) nach Anspruch 5, wobei die Mikrostrukturschicht (500) eine Vielzahl von wellenförmigen Rollstrukturen umfasst, die auf der Innenoberfläche des Aufnahmehohlraums angeordnet sind, und wobei auf einer Oberfläche jeder Rollstruktur eine Vielzahl von Mikroporen ausgebildet sind.

7. Dampfkammer (10) nach Anspruch 6, wobei die Merkmalsgröße der Mikrostruktur ein Porendurchmesser der Mikropore ist und ein Porendurchmesserbereich der Mikropore in dem Bereich von 0,1 µm bis 10 µm liegt.

8. Dampfkammer (10) nach Anspruch 5, wobei die Mikrostrukturschicht (500) eine Vielzahl von Mikroclustern umfasst, die auf die Innenoberfläche des Aufnahmehohlraums gelegt werden.

9. Dampfkammer (10) nach Anspruch 8, wobei eine Merkmalsgröße der Mikrostruktur ein Abstand zwischen zwei benachbarten Mikroclustern ist und der Abstand zwischen zwei benachbarten Mikroclustern in dem Bereich von 0,1 µm bis 10 µm liegt.

10. Dampfkammer (10) nach Anspruch 5, wobei die Mikrostrukturschicht (500) eine Vielzahl von Mikroleitungen umfasst, ein Ende der Mikroleitung mit der Wandoberfläche der Kapillarporen in der Kapillarstruktur (400) verbunden ist und das andere Ende der Mikroleitung zu dem Inneren der Kapillarpore hin verläuft.

11. Dampfkammer (10) nach Anspruch 10, wobei die Merkmalsgröße der Mikrostruktur ein Abstand zwischen zwei benachbarten Mikrolinien ist und der Abstand zwischen zwei benachbarten Mikrolinien in dem Bereich von 0,1 µm bis 10 µm liegt, wobei der Abstand zwischen zwei benachbarten Mikrolinien ein Abstand von einem Ende einer der Mikrolinien, das mit der Wandoberfläche der Kapillarporen verbunden ist, zu einem Ende der anderen Mikrolinie ist, das mit der Wandoberfläche der Kapillarporen verbunden ist.

12. Dampfkammer (10) nach Anspruch 5, wobei die Mikrostrukturschicht (500) korallenförmige Mikrovorsprünge umfasst, die auf der Wandoberfläche der Kapillarporen in der Kapillarstruktur (400) ausgebildet sind.

13. Dampfkammer (10) nach Anspruch 12, wobei die Merkmalsgröße der Mikrostruktur ein Abstand zwischen zwei benachbarten Mikrovorsprüngen ist und der Abstand zwischen zwei benachbarten Mikrovorsprüngen in dem Bereich von 0,1 µm bis 10 µm liegt.

14. Dampfkammer (10) nach Anspruch 1, wobei der Aufnahmehohlraum einen Kondensationsbereich (13) umfasst, ein erster Bereich des Kondensationsbereichs (13) mit der Mikrostrukturschicht (500) bereitgestellt ist und der erste Bereich ein anderer Bereich des Kondensationsbereichs (13) als ein mit der Kapillarstruktur (400) verbundener Bereich ist.

15. Dampfkammer (10) nach Anspruch 14, wobei der Aufnahmehohlraum ferner einen Verdampfungsbereich (12) umfasst, ein zweiter Bereich des Verdampfungsbereichs (12) mit der Mikrostrukturschicht (500) bereitgestellt ist und der zweite Bereich ein anderer Bereich des Verdampfungsbereichs (12) als ein mit der Kapillarstruktur (400) verbundener Bereich ist.

16. Dampfkammer (10) nach Anspruch 15, wobei
die Mikrostrukturschicht (500) das flüssigphasige Arbeitsmedium zu der Kapillarstruktur (400) leitet und die Kapillarstruktur (400) das flüssigphasige Arbeitsmedium zu dem Verdampfungsbereich (12) leitet.

17. Schaltungsmodul, das die Dampfkammer (10) nach einem der Ansprüche 1 bis 16, eine Leiterplatte (30) und eine auf der Leiterplatte (30) montierte elektronische Komponente umfasst, wobei die elektronische Komponente die Wärmequelle ist; und die erste Plattenabdeckung (100) über die wärmeleitfähige Oberfläche an einer Oberfläche der elektronischen Komponente anliegt.

18. Elektronische Vorrichtung, die mindestens ein Schaltungsmodul nach Anspruch 17 umfasst.

## Revendications

1. Chambre à vapeur (10), conçue pour dissiper la chaleur d'une source de chaleur, comprenant :
un premier couvercle de plaque (100) ;
un second couvercle de plaque (200), dans laquelle le premier couvercle de plaque (100) et le second couvercle de plaque (200) se chevauchent le long d'une direction de chevauchement pour former ensemble une cavité de réception scellée, et une surface conductrice de chaleur conçue pour venir en butée contre la source de chaleur est fournie sur un côté faisant partie du premier couvercle de plaque (100) et qui fait face à l'opposé de la cavité de réception, dans laquelle la direction de chevauchement est une direction dans laquelle la chambre à vapeur (10) et la source de chaleur sont empilées ; et
une structure capillaire (400), dans laquelle la structure capillaire (400) est située dans la cavité de réception, la structure capillaire (400) présente une paire d'une première surface de chevauchement (403) et une seconde surface de chevauchement (404) qui sont opposées l'une à l'autre et perpendiculaires à la direction de chevauchement, la première surface de chevauchement (403) de la structure capillaire (400) est reliée au second couvercle de plaque (200), et la seconde surface de chevauchement (404) de la structure capillaire (400) est reliée au premier couvercle de plaque (100) pour soutenir le premier couvercle de plaque (100) et le second couvercle de plaque (200) dans la direction de chevauchement, la chambre à vapeur étant
**caractérisée en ce que**
une couche de microstructure (500) est fournie sur une surface intérieure de la cavité de réception et une surface de paroi des pores capillaires dans la structure capillaire (400), et la couche de microstructure (500) est conçue pour guider un fluide moteur en phase liquide dans la chambre à vapeur (10).

2. Chambre à vapeur (10) selon la revendication 1, dans laquelle
la structure capillaire (400) comprend une pluralité de parois de structure capillaire en forme de bande (410), la pluralité de parois de structure capillaire (410) sont réparties de manière dispersée dans la cavité de réception, et un espace est formé entre la surface intérieure de la cavité de réception et une surface de chaque paroi de structure capillaire (410) autre que la première surface de chevauchement (403) et la seconde surface de chevauchement (404).

3. Chambre à vapeur (10) selon la revendication 2, dans laquelle une pluralité de premiers canaux de vapeur sont formés sur deux côtés des parois de structure capillaire (410), des seconds canaux de vapeur communiquant avec la pluralité de premiers canaux de vapeur sont prévus au niveau des extrémités des parois de structure capillaire (410), et la couche de microstructure (500) est prévue sur la surface intérieure faisant partie de la cavité de réception et qui est opposée au premier canal de vapeur et au second canal de vapeur.

4. Chambre à vapeur (10) selon l'une quelconque des revendications 1 à 3, dans laquelle une plage de dimensions de la structure capillaire (400) dans la direction de chevauchement est comprise entre 0,05 mm et 0,5 mm, et une plage d'épaisseurs de la couche de microstructure (500) est comprise entre 0,1 µm et 20 µm.

5. Chambre à vapeur (10) selon l'une quelconque des revendications 1 à 3, dans laquelle une taille de caractéristique d'une microstructure dans la couche de microstructure (500) est inférieure à une taille de caractéristique de la structure capillaire (400), dans laquelle la taille de caractéristique de la structure capillaire (400) est un diamètre de pore du pore capillaire dans la structure capillaire (400), et la taille de caractéristique de la microstructure est une taille d'une caractéristique technique liée à la mouillabilité de la couche de microstructure (500).

6. Chambre à vapeur (10) selon la revendication 5, dans laquelle la couche de microstructure (500) comprend une pluralité de structures à enroulement ondulées posées sur la surface intérieure de la cavité de réception, et une pluralité de micropores sont formés sur une surface de chaque structure à enroulement.

7. Chambre à vapeur (10) selon la revendication 6, dans laquelle la taille de caractéristique de la microstructure est un diamètre de pore du micropore, et une plage de diamètre de pore du micropore est comprise entre 0,1 µm et 10 µm.

8. Chambre à vapeur (10) selon la revendication 5, dans laquelle la couche de microstructure (500) comprend une pluralité de microagrégats disposés sur la surface intérieure de la cavité de réception.

9. Chambre à vapeur (10) selon la revendication 8, dans laquelle une taille de caractéristique de la microstructure est une distance entre deux microagrégats adjacents, et la distance entre deux microagrégats adjacents est comprise entre 0,1 µm et 10 µm.

10. Chambre à vapeur (10) selon la revendication 5, dans laquelle la couche de microstructure (500) comprend une pluralité de microlignes, une extrémité de la microligne est reliée à la surface de paroi des pores capillaires dans la structure capillaire (400), et l'autre extrémité de la microligne s'étend vers l'intérieur du pore capillaire.

11. Chambre à vapeur (10) selon la revendication 10, dans laquelle la taille de caractéristique de la microstructure est une distance entre deux microlignes adjacentes, et la distance entre deux microlignes adjacentes est comprise entre 0,1 µm et 10 µm, dans laquelle la distance entre deux microlignes adjacentes est une distance entre une extrémité, de l'une des microlignes, reliée à la surface de paroi des pores capillaires et une extrémité, de l'autre microligne, reliée à la surface de paroi des pores capillaires.

12. Chambre à vapeur (10) selon la revendication 5, dans laquelle la couche de microstructure (500) comprend des micro-saillies en forme de corail formées sur la surface de paroi des pores capillaires dans la structure capillaire (400).

13. Chambre à vapeur (10) selon la revendication 12, dans laquelle la taille de caractéristique de la microstructure est une distance entre deux micro-saillies adjacentes, et la distance entre deux micro-saillies adjacentes est comprise entre 0,1 µm et 10 µm.

14. Chambre à vapeur (10) selon la revendication 1, dans laquelle la cavité de réception comprend une région de condensation (13), une première région de la région de condensation (13) est pourvue de la couche de microstructure (500), et la première région est une région de la région de condensation (13) autre qu'une région connectée à la structure capillaire (400).

15. Chambre à vapeur (10) selon la revendication 14, dans laquelle la cavité de réception comprend en outre une région d'évaporation (12), une seconde région de la région d'évaporation (12) est pourvue de la couche de microstructure (500), et la seconde région est une région de la région d'évaporation (12) autre qu'une région reliée à la structure capillaire (400).

16. Chambre à vapeur (10) selon la revendication 15, dans laquelle la couche de microstructure (500) guide le fluide moteur en phase liquide vers la structure capillaire (400), et la structure capillaire (400) guide le fluide moteur en phase liquide vers la région d'évaporation (12).

17. Module de circuit comprenant la chambre à vapeur (10) selon l'une quelconque des revendications 1 à 16, une carte de circuit imprimé (30) et un composant électronique monté sur la carte de circuit imprimé (30), dans lequel le composant électronique est la source de chaleur ; et
le premier couvercle de plaque (100) vient en butée contre une surface du composant électronique à travers la surface conductrice de chaleur.

18. Dispositif électronique, comprenant au moins une structure de circuit selon la revendication 17.
